# EUROPÄISCHE PATENTSCHRIFT

(11) **EP 2 796 200 B1**
(45) Veröffentlichungstag und Bekanntmachung des Hinweises auf die Patenterteilung: **03.10.2018**
(21) Anmeldenummer: 14159935.7
(22) Anmeldetag: 14.03.2014
(51) Int. Cl.: B29C 65/16, B01L 3/00, B29C 65/00, F16K 99/00, B81C 3/00, G01N 1/28, B29L 31/00, B65B 3/00

(54) **MIKROFLUIDISCHE ANALYSEKARTUSCHE UND VERFAHREN ZU IHRER HERSTELLUNG**
MICROFLUID ANALYSIS CARTRIDGE AND METHOD FOR ITS FABRICATION
CARTOUCHE D'ANALYSE MICROFLUIDIQUE ET PROCÉDÉ DESTINÉ À SA FABRICATION

(30) Priorität: 26.04.2013 DE 102013207683
(43) Veröffentlichungstag der Anmeldung: 29.10.2014
(73) Patentinhaber: ROBERT BOSCH GMBH, 70442 Stuttgart (DE)
(72) Erfinder: Laermer, Franz, 71263 Weil Der Stadt (DE); Steigert, Juergen, 70176 Stuttgart (DE); Zinober, Sven, 71292 Friolzheim (DE)

(56) Entgegenhaltungen:
- EP-A1- 2 138 233
- EP-A1- 2 322 277
- EP-A2- 1 520 621
- WO-A1-2011/042422
- CN-A- 102 319 956
- US-A1- 2006 076 068
- US-A1- 2007 084 706
- US-A1- 2010 167 384

## Beschreibung

### Stand der Technik

Die vorliegende Erfindung bezieht sich auf ein Verfahren zum Herstellen einer pneumatisch betätigbaren mikrofluidischen Analysekartusche sowie auf die entsprechende Analyskartusche selbst.

Eine Analysekartusche kann dazu ausgebildet sein, zumindest einen biochemischen Prozess in einer einmal verwendbaren Einheit durchzuführen.

Dazu wird die Analysekartusche mit einer Probe bestückt und in ein Analysegerät eingelegt. Im Analysegerät wird der Prozess gesteuert und ausgewertet. Nach Abschluss des Prozesses wird die Kartusche aus dem Analysegerät entfernt und entsorgt.

Die WO 2011/042422 A1 beschreibt ein Fügeverfahren und Fügeverbindung für mikrofluidische Bauteile.

Die EP 1 520 621 A2 offenbart ein mikrofluidisches Analysemodul, das aus einer Mehrzahl direkt miteinander verbundener Lagen aufgebaut ist. Unter Verwendung von Überdruck oder Unterdruck kann eine Membran bewegt werden, um eine Verbindung zweier Kanäle zu öffnen oder zu schließen. Die US 2010/0167384 A1 offenbart ein mikrofluidisches Misch- und Analysegerät und die EP 2 322 277 A1 offenbart einen mikrofluidischen Chip mit einer Ausnehmung zur Aufnahme eines Fluids und einem gegenüber der Ausnehmung angeordneten Druckkanal. Der Druckkanal ist mit einer Membran verschlossen.

### Offenbarung der Erfindung

Vor diesem Hintergrund wird mit der vorliegenden Erfindung ein Verfahren zum Herstellen einer pneumatisch betätigbaren mikrofluidischen Analysekartusche und eine Analysekartusche selbst gemäß den Hauptansprüchen vorgestellt.

Vorteilhafte Ausgestaltungen ergeben sich aus den jeweiligen Unteransprüchen und der nachfolgenden Beschreibung.

Eine Analysekartusche für einen Analyseprozess weist zumindest zwei funktional verschiedene Lagen auf, die benachbart zueinander in einer vordefinierten Lage zueinander angeordnet sind. In einer ersten Lage wird der Analyseprozess durchgeführt. Die erste Lage wird fluiddicht verschlossen, um Fluide des Analyseprozesses zu bevorraten und Reaktionsprodukte aufzunehmen. In einer zweiten Lage werden Bewegungen und Kräfte bereitgestellt, um den Analyseprozess in der ersten Lage durchzuführen. Zum Bereitstellen der Bewegungen und Kräfte werden ebenfalls fluiddicht verschlossene Kammern benötigt, um Druck oder Unterdruck darin aufbauen zu können.

Um eine fluiddichte Versiegelung einer Kartusche zu erreichen, kann die Kartusche mit einer Membran versiegelt werden. Dabei kann jede der Lagen separat versiegelt werden, um eine optimale Dichtheit zu erreichen. Anschließend können die Lagen zu der Kartusche zusammengefügt werden.

Es wird ein Verfahren zum Herstellen einer pneumatisch betätigbaren mikrofluidischen Analysekartusche vorgestellt, wobei das Verfahren die folgenden Schritte aufweist:
Bereitstellen eines Fluidikteils der Analysekartusche und eines Pneumatikteils der Analysekartusche, wobei der Fluidikteil dazu ausgebildet ist, fluidische Grundoperationen eines biochemischen Analyseprozesses auszuführen und der Pneumatikteil dazu ausgebildet ist, die Grundoperationen unter Verwendung von Luftdruck anzusteuern;
Verschließen einer Fügeseite des Fluidikteils mit einer ersten fluiddichten elastischen Membran und Verschließen einer Fügeseite des Pneumatikteils mit einer zweiten Membran;
Ausrichten der der Fügeseite des Fluidikteils gegenüber der Fügeseite des Pneumatikteils; und
Verbinden des Fluidikteils und des Pneumatikteils, um die Analysekartusche zu erhalten.

Im Schritt des Ausrichtens kann die erste Membran an der zweiten Membran ausgerichtet werden.

Unter einer pneumatisch betätigbaren Analysekartusche kann eine Einheit zum Verwenden in einem Analysegerät verstanden werden, die mit für zumindest einen chemischen und/oder biochemischen Analyseprozess notwendigen Reagenzien ausgestattet ist und dazu ausgebildet ist, den oder die entsprechenden Analyseprozesse in entsprechenden Einrichtungen auszuführen, wenn das Analysegerät Energie in Form von Druck bereitstellt. Ein Fluidikteil kann Kanäle, Kammern und Strukturen zum Ausführen des Analyseprozesses aufweisen. Ein Pneumatikteil kann Kammern, Kanäle und Strukturen zum Ansteuern des Analyseprozesses unter Verwendung von Überdruck und/oder Unterdruck aufweisen. Die erste Membran und die zweite Membran können sich in einer Wirkung ergänzen. Die erste Membran und die zweite Membran können den Fluidikteil und den Pneumatikteil sicher voneinander trennen. Ein Ausrichten kann ein bestimmtes Lagern sein. Beispielsweise kann das Ausrichten ein Fixieren eines ersten Punkts in drei Achsen, eines zweiten Punkts in zwei der drei Achsen und eines dritten Punkts in einer der drei Achsen sein. Beispielsweise können die Membranen flächig aneinander anliegen, wodurch die Membranen in einer Ebene quer zu den Membranen fixiert sind. Der erste und zweite Punkt kann an einer Bewegung in einer ersten Hauptrichtung der Ebene der Membranen gehindert werden, während der erste Punkt ferner an einer Bewegung in einer zweiten Hauptrichtung der Ebene gehindert wird. Ein Verbinden kann ein kraftschlüssiges Verbinden, ein formschlüssiges Verbinden und/oder ein stoffschlüssiges Verbinden sein.

Die erste Membran und der Fluidikteil und alternativ oder ergänzend die zweite Membran und der Pneumatikteil können unter Verwendung von Laserenergie verbunden werden. Die Laserenergie kann auf die Fügeseite gerichtet sein. Die Laserenergie kann zumindest ein Material an einer Grenzfläche zwischen der Membran und dem Teil aufschmelzen, damit eine stoffschlüssige Verbindung erreicht wird. Laserenergie kann gut gerichtet werden.

Die erste Membran und die zweite Membran werden zumindest teilflächig stoffschlüssig miteinander verbunden. Durch die stoffschlüssige Verbindung können Zugkräfte über beide Membranen übertragen werden.

Der Fluidikteil und der Pneumatikteil werden mechanisch aufeinander gepresst. Durch die kraftschlüssige Verbindung kann eine gute Dichtheit erreicht werden.

Die erste Membran und alternativ oder ergänzend die zweite Membran können zumindest teilflächig beschichtet werden, um Diffusionseigenschaften und alternativ oder ergänzend Permeationseigenschaften der Membran zu verändern. Eine Beschichtung kann nach dem Verschließen aufgebracht werden. Dadurch kann beispielsweise mit dem Laser vor dem Beschichten ohne Einschränkungen verschlossen werden und die Beschichtung kann unabhängig von einer Verschlusskontur aufgebracht werden. Die Beschichtung ist nach dem Verbinden zwischen den Membranen gut geschützt.

Eine dritte elastische Membran kann zwischen der ersten Membran und der zweiten Membran angeordnet werden. Durch eine dritte Membran können die Membranen selektiv verstärkt werden, beispielsweise um Kräfte aus dem Pneumatikteil verbessert auf den Fluidikteil übertragen zu können.

Der Fluidikteil und alternativ oder ergänzend der Pneumatikteil kann mit einer Einrichtung zum Abdichten bereitgestellt werden, die aus der Fügefläche hervorsteht, wobei die Einrichtung zum Abdichten in die erste Membran und alternativ oder ergänzend in die zweite Membran gepresst werden kann, um den Fluidikteil und den Pneumatikteil fluiddicht zu verbinden. Eine Einrichtung zum Abdichten kann eine umlaufend geschlossene Dichtlippe sein. Die Einrichtung zum Abdichten kann einen sicheren Verschluss des Fluidikteils und/oder des Pneumatikteils verbessern.

Der Fluidikteil und der Pneumatikteil können mit zumindest zwei Führungselementen bereitgestellt werden und im Schritt des Ausrichtens können der Fluidikteil und der Pneumatikteil unter Verwendung der Führungselemente aneinander ausgerichtet werden. Die Führungselemente können zum Ausrichten des ersten Punkts und des zweiten Punkts verwendet werden. Zwei Führungselemente können bei flächigem Kontakt der Membranen für eine statisch bestimmte Lagerung sorgen.

Die erste Membran kann an den Führungselementen des Fluidikteils oder des Pneumatikteils ausgerichtet werden. Alternativ oder ergänzend kann die zweite Membran an den Führungselementen des Pneumatikteils oder des Fluidikteils ausgerichtet werden. Die Membranen können vor dem Verschließen an den Führungselementen ausgerichtet werden. Dadurch können die Membranen sicher und schnell positioniert werden.

Der Fluidikteil und alternativ oder ergänzend der Pneumatikteil kann unter Druck gesetzt werden, um die erste Membran mit der zweiten Membran zu verbinden. Durch den Druck kann eine Flächenpressung zwischen den Membranen erreicht werden und die Verbindung verbessert werden.

Weiterhin wird eine Vorrichtung zum Herstellen einer pneumatisch betätigbaren mikrofluidischen Analysekartusche vorgestellt, wobei die Vorrichtung die folgenden Merkmale aufweist:
eine Einrichtung zum Bereitstellen eines Fluidikteils der Analysekartusche und eines Pneumatikteils der Analysekartusche, wobei der Fluidikteil dazu ausgebildet ist, fluidische Grundoperationen eines biochemischen Analyseprozesses auszuführen und der Pneumatikteil dazu ausgebildet ist, die Grundoperationen unter Verwendung von Luftdruck anzusteuern;
eine Einrichtung zum Verschließen einer Fügeseite des Fluidikteils mit einer ersten fluiddichten elastischen Membran und/oder zum Verschließen einer Fügeseite des Pneumatikteils mit einer zweiten Membran;
eine Einrichtung zum Ausrichten der Fügeseite des Fluidikteils gegenüber der Fügeseite des Pneumatikteils; und
eine Einrichtung zum Verbinden des Fluidikteils und des Pneumatikteils, um die Analysekartusche zu erhalten.

Unter einer Vorrichtung kann vorliegend ein elektrisches Gerät verstanden werden, das Sensorsignale verarbeitet und in Abhängigkeit davon Steuer- und/oder Datensignale ausgibt. Die Vorrichtung kann eine Schnittstelle aufweisen, die hard- und/oder softwaremäßig ausgebildet sein kann. Bei einer hardwaremäßigen Ausbildung können die Schnittstellen beispielsweise Teil eines sogenannten System-ASICs sein, der verschiedenste Funktionen der Vorrichtung beinhaltet. Es ist jedoch auch möglich, dass die Schnittstellen eigene, integrierte Schaltkreise sind oder zumindest teilweise aus diskreten Bauelementen bestehen. Bei einer softwaremäßigen Ausbildung können die Schnittstellen Softwaremodule sein, die beispielsweise auf einem Mikrocontroller neben anderen Softwaremodulen vorhanden sind.

Von Vorteil ist auch ein Computerprogrammprodukt mit Programmcode, der auf einem maschinenlesbaren Träger wie einem Halbleiterspeicher, einem Festplattenspeicher oder einem optischen Speicher gespeichert sein kann und zur Durchführung des Verfahrens nach einer der vorstehend beschriebenen Ausführungsformen verwendet wird, wenn das Programmprodukt auf einem Computer oder einer Vorrichtung ausgeführt wird.

Eine pneumatisch betätigbare mikrofluidische Analysekartusche weist die folgenden Merkmale auf:
einen Fluidikteil, der dazu ausgebildet ist, fluidische Grundoperationen eines biochemischen Analyseprozesses auszuführen und einen Pneumatikteil, der dazu ausgebildet ist, die Grundoperationen unter Verwendung von Druckluft anzusteuern.

Die pneumatisch betätigbare mikrofluidische Analysekartusche weist eine erste elastische Membran zum Verschließen der Fügeseite des Fluidikteils und eine zweite elastische Membran zum Verschließen der Fügeseite des Pneumatikteils auf. Dabei sind die erste Membran und die zweite Membran zwischen dem Fluidikteil und dem Pneumatikteil angeordnet. Vorteilhafterweise können sich die erste Membran und die zweite Membran darin unterscheiden, dass sie für Laserlicht unterschiedlicher Wellenlängen durchlässig sind. Dadurch kann zum Laserschweißen des Fluidikteils Laserlicht einer ersten Wellenlänge, für die die erste Membran durchlässig ist, und zum Laserschweißen des Pneumatikteils Laserlicht einer zweiten Wellenlänge, für die die zweite Membran durchlässig ist, eingesetzt werden.

Die Fügeseite des Fluidikteils und die Fügeseite des Pneumatikteils können aus unterschiedlichen Materialien bestehen. Beispielsweise können das gesamte Fluidikteil und das gesamte Pneumatikteil aus unterschiedlichen Materialien hergestellt sein. Die unterschiedlichen Materialien können unterschiedliche Materialeigenschaften aufweisen, die beispielsweise ungeeignet für eine direkte Fügeverbindung zwischen den unterschiedlichen Materialien, beispielsweise durch Laserschweißen, sind. Unter Verwendung der Membranen können ein solches Fluidikteil und ein solches Pneumatikteil dennoch zuverlässig zusammengefügt werden.

Die Erfindung wird nachstehend anhand der beigefügten Zeichnungen beispielhaft näher erläutert. Es zeigen:
- Fig. 1: eine Darstellung eines Fluidikteils und eines Pneumatikteils einer Analysekartusche gemäß einem Ausführungsbeispiel der vorliegenden Erfindung;
- Fig. 2: eine Darstellung einer Analysekartusche gemäß einem Ausführungsbeispiel der vorliegenden Erfindung;
- Fig. 3: ein Ablaufdiagramm eines Verfahrens zum Herstellen einer Analysekartusche gemäß einem Ausführungsbeispiel der vorliegenden Erfindung;
- Fig. 4: eine Darstellung eines Führungselements zum Verbinden eines Fluidikteils und eines Pneumatikteils einer Analysekartusche gemäß einem Ausführungsbeispiel der vorliegenden Erfindung;
- Fig. 5: eine Darstellung eines Fluidikteils mit einer Einrichtung zum Abdichten einer Analysekartusche gemäß einem Ausführungsbeispiel der vorliegenden Erfindung;
- Fig. 6: eine Darstellung eines Fluidikteils und eines Pneumatikteils mit je einer Einrichtung zum Abdichten einer Analysekartusche gemäß einem Ausführungsbeispiel der vorliegenden Erfindung;
- Fig. 7: eine Darstellung eines Fluidikteils und eines Pneumatikteils mit Führungselementen gemäß einem Ausführungsbeispiel der vorliegenden Erfindung;
- Fig. 8: eine Darstellung einer Analysekartusche mit Führungselementen gemäß einem Ausführungsbeispiel der vorliegenden Erfindung;
- Fig. 9: eine Darstellung eines Fluidikteils und eines Pneumatikteils mit Verbindungselementen gemäß einem Ausführungsbeispiel der vorliegenden Erfindung;
- Fig. 10: eine Darstellung einer Analysekartusche mit Verbindungselementen gemäß einem Ausführungsbeispiel der vorliegenden Erfindung;
- Fig. 11: eine Darstellung eines Fluidikteils mit beschichteter Membran gemäß einem Ausführungsbeispiel der vorliegenden Erfindung;
- Fig. 12: eine Darstellung einer Analysekartusche mit beschichteter Membran gemäß einem Ausführungsbeispiel der vorliegenden Erfindung;
- Fig. 13: eine Darstellung einer Analysekartusche mit teilweise beschichteter Membran gemäß einem Ausführungsbeispiel der vorliegenden Erfindung;
- Fig. 14: eine Darstellung einer Analysekartusche mit Nieten gemäß einem Ausführungsbeispiel der vorliegenden Erfindung;
- Fig. 15: eine Darstellung einer Analysekartusche mit Dichtrand gemäß einem Ausführungsbeispiel der vorliegenden Erfindung;
- Fig. 16: eine Darstellung eines Fluidikteils und eines Pneumatikteils mit Führungselementen vor dem Ausrichten gemäß einem Ausführungsbeispiel der vorliegenden Erfindung;
- Fig. 17: eine Darstellung eines Fluidikteils und eines Pneumatikteils mit Führungselementen während des Ausrichtens gemäß einem Ausführungsbeispiel der vorliegenden Erfindung;
- Fig. 18: eine Darstellung eines Fluidikteils und eines Pneumatikteils mit Führungselementen während des Verbindens gemäß einem Ausführungsbeispiel der vorliegenden Erfindung;
- Fig. 19: eine Darstellung einer Analysekartusche mit einem ersten Fluidikteil und einem zweiten Fluidikteil gemäß einem Ausführungsbeispiel der vorliegenden Erfindung; und
- Fig. 20: ein Blockschaltbild einer Vorrichtung zum Herstellen einer Analysekartusche gemäß einem Ausführungsbeispiel der vorliegenden Erfindung.

In der nachfolgenden Beschreibung günstiger Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

Die Durchführung biochemischer Prozesse basiert auf der Handhabung von Flüssigkeiten. Typischerweise kann diese Handhabung manuell mit Hilfsmitteln wie Pipetten, Reaktionsgefäßen, aktiven Sondenoberflächen oder Laborgeräten durchgeführt werden. Durch Pipettierroboter oder Spezialgeräte können diese Prozesse zum Teil automatisiert werden.

Ein Lab-on-a-Chip (LoC) System (sogenanntes Westentaschenlabor oder Chiplabor) ist ein mikrofluidisches System, welches die gesamte Funktionalität eines makroskopischen Labors auf einem beispielsweise nur plastikkartengroßen Kunststoffsubstrat unterbringt. Lab-on-a-Chip-Systeme bestehen typischerweise aus zwei Hauptkomponenten. Die erste Hauptkomponente ist ein Testträger oder eine Einwegkartusche, die Strukturen und Mechanismen für die Umsetzung der fluidischen Grundoperationen (z. B. Mischer) beinhaltet, welche aus passiven Komponenten wie Kanäle, Reaktionskammern, vorgelagerten Reagenzien oder auch aktiven Komponenten wie Ventilen oder Pumpen bestehen können. Die zweite Hauptkomponente sind Aktuationseinheiten, Detektionseinheiten und Steuereinheiten. Das System ermöglicht es, biochemische Prozesse voll automatisiert zu prozessieren.

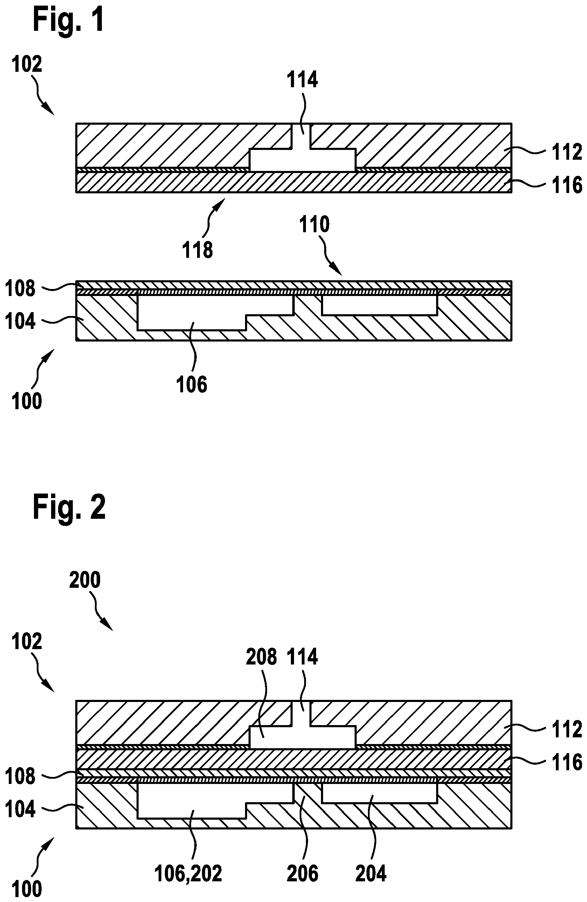

Fig. 1 zeigt eine Darstellung eines Fluidikteils 100 und eines Pneumatikteils 102 einer Analysekartusche gemäß einem Ausführungsbeispiel der vorliegenden Erfindung. Der Fluidikteil 100 weist ein erstes Substrat 104, eine erste Struktur 106 und eine erste Membran 108 auf. Die erste Struktur 106 ist an einer Fügefläche 110 des Fluidikteils 100 von der ersten Membran 108 fluiddicht verschlossen. Der Pneumatikteil 102 weist ein zweites Substrat 112, eine zweite Struktur 114 und eine zweite Membran 116 auf. Die zweite Struktur 114 ist an einer Fügefläche 118 des Pneumatikteils 102 durch die zweite Membran 116 verschlossen. Die Fügeflächen 110, 118 sind einander zugewandt ausgerichtet. In der Darstellung des in Fig. 1 dargestellten Ausführungsbeispiels ist der Fluidikteil 100 unten und der Pneumatikteil 102 oben angeordnet. Das erste Substrat 104 ist als Absorber zum Absorbieren von Laserstrahlung ausgebildet. Die erste Membran 108 ist aus einem für die Laserstrahlung transparenten Material ausgebildet. Dadurch kann beim Verschließen des Fluidikteils 100 die Laserstrahlung durch die erste Membran 108 dringen, um das erste Substrat 104 zumindest oberflächlich zu erwärmen, bis das erste Substrat 104 auf einer von der Laserstrahlung bestrahlten Fläche (Laserschweißfläche) aufschmilzt, um sich fluiddicht mit der ersten Membran 108 zu verbinden. Das zweite Substrat 112 ist aus einem für die Laserstrahlung transparenten Material ausgebildet. Die zweite Membran 116 ist als Absorber zum Absorbieren der Laserstrahlung ausgebildet.

Dadurch kann beim Verschließen des Pneumatikteils 102 die Laserstrahlung durch das zweite Substrat 112 dringen, um die zweite Membran 116 zumindest oberflächlich zu erwärmen, bis die zweite Membran 116 auf der von der Laserstrahlung bestrahlten Fläche aufschmilzt, um sich fluiddicht mit dem zweiten Substrat 112 zu verbinden.

Fig. 2 zeigt eine Darstellung einer Analysekartusche 200 gemäß einem Ausführungsbeispiel der vorliegenden Erfindung. Die Analysekartusche 200 weist einen Fluidikteil 100 und einen Pneumatikteil 102 auf, wie sie in Fig. 1 dargestellt sind. Die erste Membran 108 ist zu der zweiten Membran 116 ausgerichtet und der Fluidikteil 100 ist mit dem Pneumatikteil 102 verbunden. Die erste Membran 108 ist unmittelbar benachbart zu der zweiten Membran 116 angeordnet. Die erste Membran 108 ist gemäß diesem Ausführungsbeispiel dünner als die zweite Membran 116. Alternativ können beide Membranen 108, 116 gleich dick sein, oder es kann die erste Membran 108 dicker als die zweite Membran 116 sein. Die erste Struktur 106 weist eine erste Kammer 202 und eine zweite Kammer 204 auf. Die erste Kammer 202 ist durch einen Steg 206 von der zweiten Kammer 204 getrennt. Der Steg liegt an der ersten Membran 108 an und trennt die beiden Kammern 202, 204 fluiddicht voneinander, wenn die Membran 108 in einer Ausgangslage ist. Die zweite Struktur 114 weist eine dritte Kammer 208 auf. Die dritte Kammer 208 ist über einen Luftkanal mit einer Rückseite des Pneumatikteils 102 verbunden. Wenn über den Luftkanal Luft aus der dritten Kammer 208 abgezogen wird, werden die erste Membran 108 und die zweite Membran 116 in die dritte Kammer 208 gezogen. Dadurch entsteht ein Spalt zwischen dem Steg 206 und der ersten Membran 108. Durch den Spalt ist die erste Kammer 202 mit der zweiten Kammer 204 verbunden. Durch den Spalt kann Flüssigkeit zwischen den Kammern 202, 204 ausgetauscht werden, um einen Analyseprozess im Fluidikteil 100 durchzuführen. Die Membranen 108, 116 und der Steg 206 wirken somit als Ventil zum Steuern eines Flüssigkeitsaustauschs zwischen der ersten Kammer 202 und der zweiten Kammer 204.

In den Figuren 1 und 2 ist ein Längsschnitt eines Aufbaus 200 dargestellt. In den Substraten 104, 112 befinden sich Kanäle 106, 114. Diese werden jeweils über eine Membran 108, 116 abgedichtet. Jeweils das Substrat 104, 112 oder die elastische Membran 108, 116 können als Absorber ausgelegt sein. Je nach den geforderten Eigenschaften können die beiden Substrate 104, 112 oder Membranen 108, 116 aus unterschiedlichen Materialien sein. Die Materialien von Substrat 104, 112 und Membran 108, 116 sind vorteilhafterweise für den jeweiligen Laserschweißprozess aufeinander ausgelegt. Für das Fügen der beiden 2-Layer-Stacks 100, 102 können beliebige Fügeverfahren eingesetzt werden.

Das hier dargestellte Ausführungsbeispiel eines Lab-on-Chip Systems 200 ist als pneumatische Plattform ausgebildet. Eine Kartusche 200 nach dem hier vorgestellten Ansatz ist typischerweise aus mindestens 3 Lagen aufgebaut, wobei sich zwischen zwei starren Lagen 104, 112, in welchen die fluidischen und pneumatischen Strukturen 106, 114 integriert sind, zumindest eine elastische Membran 108, 116 befinden. Der Multi-Lagen Aufbau kann mittels Laserschweißen erfolgen. Hierbei werden jeweils mindestens zwei der Layer mit einer Kraft F < 2,5 kN zusammengepresst. Einer der Layer dient als Absorber und absorbiert die Energie des eingestrahlten Laserstrahls. Dadurch werden die beiden Layermaterialien an ihrer Grenzfläche aufgeschmolzen und die Polymerketten können sich mechanisch verbinden. Beim Abkühlen wird dieser Zustand "eingefroren" und es entsteht ein mechanischer Bond. Somit werden zwei Substratlagen über eine Fügelage miteinander verbunden und abgedichtet.

Die aktive Steuerung von Fluiden auf Lab-on-Chip Kartuschen 200 verlangt Ventile, welche im fluidischen Netzwerk 106 integriert sind. Über Anlegen eines Überdrucks in den pneumatischen Strukturen 114 können die elastischen Membranen 116, 108 ausgelenkt werden und drücken den fluidischen Kanal 106 ab, wobei der Fluidfluss zum Erliegen kommt. Mit diesem Prinzip lassen sich weitere fluidische Einheitsoperatoren wie Pumpen, Mischer oder Reaktionskammern realisieren.

Mittels dem hier vorgestellten 4-lagigen Aufbau basierend aus "Thermoplast - thermoplastischem Elastomer (TPE) - thermoplastischem Elastomer (TPE) - Thermoplast" lassen sich robuste LoC-Kartuschen 200 aufbauen. Dabei können die Materialkombinationen beim Laserschweißen präzise aufeinander abgestimmt werden, eine mechanische Verbindung der Polymerketten kann optimiert werden und ein robuster Bond resultiert. Die TPE-Mittelschicht 108, 116 kann als Absorber ausgeführt sein. Zum Fügen mittels Laserschweißen kann somit der Laserstrahl direkt auf den Absorber 108, 116 gestrahlt werden. Vorteil des Laserschweißens ist hierbei, dass zwei Layer nur selektiv an definierten Stellen gefügt werden. Da die Substrate 104, 112 strukturiert sind, würde der Laserstrahl an Kammern, Kanälen oder Stegen abgelenkt werden, wenn er durch das Substrat 104, 112 wirken würde, wodurch eine durchgehende und fluidisch dichte Schweißkontur des fluidischen Netzwerks schwer realisiert werden kann. Zwei der Lagen werden über eine Fügelage miteinander verbunden und abgedichtet. Dies erweitert mögliche Materialkombinationen, da die Laserschweißfähigkeit einfach gewährleistet werden kann.

Oberflächeneigenschaften der Materialien, insbesondere der elastischen Membrane 108, 116 sind für das fluidische Netzwerk 106 kritisch, da sich biologische Bestandteile in der Flüssigkeit wie Proteine, Enzyme, DNA-Stränge, Nukleotide oder Antikörper unspezifisch an die Oberflächen binden können und somit aus der Lösung "herausgefischt" werden könnten und für den weiteren Test nicht mehr zur Verfügung stehen würden. Weitere wichtige Parameter der eingesetzten Materialien sind das Permeations- bzw. Diffusionsverhalten, insbesondere für Wasser, Wasserdampf, Ethanol und Sauerstoff.

Die Oberflächeneigenschaften können durch eine Oberflächenmodifikation an der Grenzfläche von elastischer Membran 108, 116 und Substrat 104, 112, also der Fügefläche verbessert werden.

Mit dem hier vorgestellten Ansatz lassen sich mikrofluidische Lab-on-Chip Kartuschen 200 aus homogenen wie auch aus heterogenen Materialkombinationen realisieren. Die Kartusche 200 besteht typischerweise aus mindestens zwei Substraten 104, 112, einem Pneumatiklayer (Layer 1) 102 und einem Fluidiklayer (Layer 2) 100, zwischen welchen sich zwei elastomere Membranen (Layer 3) 108, 116 befinden. In dem Pneumatiklayer 102 wie auch dem Fluidiklayer 100 befinden sich fluidische Netzwerke 106, 114, welche typischerweise aus Kanälen, Kammern und/oder Durchlöchern, bestehen. Die Kanäle weisen typischerweise Durchmesser kleiner 1mm auf und Kanalbreiten und Tiefen von 1-3000 µm. Die integrierten Kammern können typischerweise ein Volumen größer 1 µl bis hin zu 5 ml fassen. Die Durchlöcher haben Durchmesser von 50 µm bis 3 mm. Die Pneumatiklayer 102 und Fluidiklayer 100 weisen typischerweise eine Dicke von 1-10 mm auf. Die elastischen Membranen 108, 116 haben typischerweise eine Dicke von 10-500 µm. Die Kartuschen 200 sind dazu ausgebildet, fluidische Einheitsoperationen beispielsweise durch Ventile, Pumpen, Mischer und/oder Aliquotingstrukturen zu realisieren.

Der Fluidiklayer 104 und der Pneumatiklayer 112 werden in einer Ausführungsform jeweils mit einer elastischen Membran 108, 116 verschweißt. Somit ist z. B. die elastische Membran 108, 116 nicht als Absorber festgelegt. Je nach Stack kann das Substrat 104, 112 oder die elastische Membran 108, 116 als Absorber ausgelegt sein. Ist das Substrat 104, 112 als Absorber ausgelegt, kann ein Energieeintrag durch die elastische Membran 108, 116 erfolgen, sodass der Laserstrahl nicht durch Kanalwände oder Kammern wie sie im Substrat 104, 112 vorhanden sind, abgelenkt wird. Hierbei stellt das Substrat 104, 112 den Absorber dar und die Membran 108, 116 ist für die eingestrahlte Wellenlänge transparent. Somit treten in Durchtritt des Laserstrahls durch die Membran 108, 116 keine Brechungs- und Streuungseffekte auf, wodurch kontinuierliche und somit fluidisch dichte Schweißkonturen um das fluidische Netzwerk 106 herum erzeugt werden können.

Da jeweils nur das Substrat 104, 112 und die zugehörige Membran 108, 116 bezüglich des Fügens mittels Laserschweißprozess aufeinander abgestimmt werden, können für die Membranen 108, 116 und Substrate 104, 112 unterschiedliche Materialien eingesetzt werden. Das Fügen der 2-Layer-Stacks 100, 102 kann dann mit belieben Fügeverfahren durchgeführt werden, z. B. adhäsiver Bond oder Flächenpressung.

Als Substrate für den Fluidiklayer 104 kommen typischerweise Thermoplaste wie COP, COC, PC, PA, PU, PP, PET oder PMMA infrage. Alternativ können auch strukturierte Gläser oder Metalle verwendet werden. In einem Ausführungsbeispiel findet die Realisierung der mechanischen Pressung unter Vakuum statt, um den Einschluss von Luftblasen zwischen Fluidiklayer 104 und elastischer Membran 108 zu vermeiden. Alternativ oder ergänzend kann hier auch das pneumatische Netzwerk 114 und/oder das fluidische Netzwerk 106 unter Druck gesetzt werden, was sich besonders beim Aufbau mit zwei Membranen, die adhäsiv verbunden werden, vorteilhaft erweisen kann, um insbesondere im Ventilbereich eine gute Bindung zu erzielen.

Im Aufbau muss die elastische Membran 108, 116 nicht zwingend an Ober- und Unterseite mit dem Pneumatik- bzw. Fluidiklayer 104, 112 oder einer weiteren elastischen Membran gefügt sein. In einem Ausführungsbeispiel findet das Fügen selektiv nur mit einem der Layer statt.

In einer Ausführungsform werden für die unterschiedlichen Substratlayer heterogene Materialien eingesetzt, z. B. COC und PC. In einer Ausführungsform sind die Substratmaterialien so aufeinander abgestimmt, dass der thermische Ausdehnungskoeffizient für den Bereich von -30 bis +100°C nahezu identisch ist (z. B. PC 70*10⁻⁶/K und COP 60*10⁻⁶/K) bzw. maximal 20% voneinander abweichen.

Des Weiteren können im Aufbau von Multilayersystemen die einzelnen Layer variabel und flexibel als Absorber oder transparent für Wellenlängen des Laserschweißens ausgelegt und kombiniert werden. In einem Ausführungsbeispiel ist der Pneumatiklayer 112 als Absorber und die zugehörige elastische Membran 116 transparent ausgelegt, während der Fluidiklayer 104 transparent ausgelegt ist, wobei Pneumatik- und Fluidiklayer 104, 112 jeweils mit einer elastischen Membran 108, 116 gefügt werden und die zum Fluidiklayer 104 zugehörige elastische Membran 108 absorbierend ausgelegt ist.

In einer Ausführungsform ist das pneumatische Netzwerk 114 auch mit einer Flüssigkeit ganz oder teilweise segmentiert gefüllt, wodurch eine hydraulische Aktuation erfolgt.

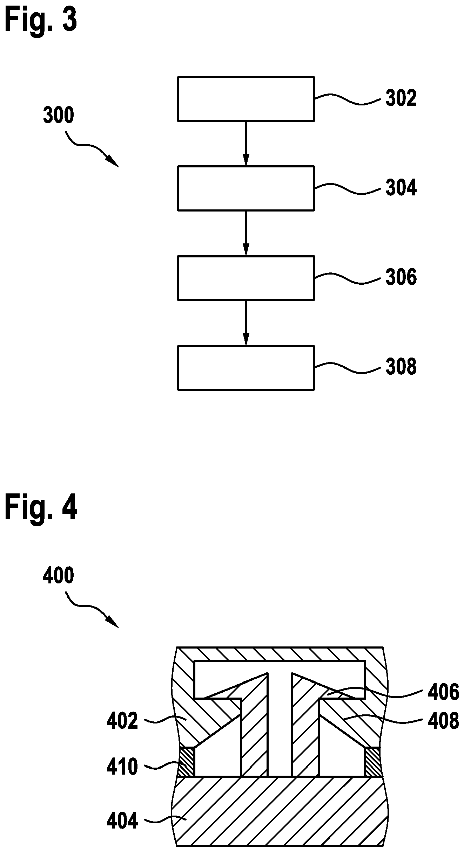

Fig. 3 zeigt ein Ablaufdiagramm eines Verfahrens 300 zum Herstellen einer pneumatisch betätigbaren mikrofluidischen Analysekartusche gemäß einem Ausführungsbeispiel der vorliegenden Erfindung. Das Verfahren 300 weist einen Schritt 302 des Bereitstellens, einen Schritt 304 des Verschließens, einen Schritt 306 des Ausrichtens und einen Schritt 308 des Verbindens auf. Im Schritt 302 des Bereitstellens werden ein Fluidikteil der Analysekartusche und ein Pneumatikteil der Analysekartusche bereitgestellt, wobei der Fluidikteil dazu ausgebildet ist, fluidische Grundoperationen eines biochemischen Analyseprozesses auszuführen und der Pneumatikteil dazu ausgebildet ist, die Grundoperationen unter Verwendung von Luftdruck anzusteuern. Im Schritt 304 des Verschließens wird eine Fügeseite des Fluidikteils mit einer ersten fluiddichten elastischen Membran verschlossen. Weiterhin wird eine Fügeseite des Pneumatikteils mit einer zweiten Membran verschlossen. Im Schritt 306 des Ausrichtens werden die erste Membran und die zweite Membran aneinander ausgerichtet. Im Schritt 308 des Verbindens werden der Fluidikteil und der Pneumatikteil miteinander verbunden, um die Analysekartusche zu erhalten.

In einem Ausführungsbeispiel werden im Schritt 304 des Verschließens die erste Membran und der Fluidikteil und alternativ oder ergänzend die zweite Membran und der Pneumatikteil unter Verwendung von Laserenergie verbunden, wobei die Laserenergie auf die Fügeseite gerichtet ist. Die Laserenergie wird in Form von gerichtetem Laserlicht durch die Membran auf das darunter angeordnete Substrat gerichtet. Dabei wird Material der Membran und/oder Material des Substrats im Bereich einer Grenzfläche zwischen dem Substrat und der Membran plastifiziert. Die Membran verbindet sich beim Abkühlen des plastifizierten Materials stoffschlüssig mit dem Substrat.

In einem Ausführungsbeispiel werden im Schritt 308 des Verbindens die erste Membran und die zweite Membran zumindest teilflächig stoffschlüssig miteinander verbunden. Beispielsweise können die Membranen miteinander unter Verwendung einer Klebeschicht verklebt werden.

In einem Ausführungsbeispiel werden im Schritt 308 des Verbindens der Fluidikteil und der Pneumatikteil mechanisch aufeinander gepresst. Dabei können Fügekräfte zwischen dem Substrat des Fluidikteils und dem Substrat des Pneumatikteils aufgebaut werden, die beide Teile aneinander drücken.

In einem Ausführungsbeispiel wird im Schritt 304 des Verschließens die erste Membran und alternativ oder ergänzend die zweite Membran zumindest teilflächig beschichtet, um Diffusionseigenschaften und alternativ oder ergänzend Permeationseigenschaften der Membran zu verändern. Beispielsweise kann zumindest eine der Membranen metallisiert werden, um eine effektive Diffusionsbarriere zu erhalten.

In einem Ausführungsbeispiel wird im Schritt 306 des Ausrichtens eine dritte elastische Membran zwischen der ersten Membran und der zweiten Membran angeordnet. Die dritte Membran kann als Versteifung für die erste Membran und/oder die zweite Membran ausgebildet sein. Die dritte Membran kann mit zumindest einer der Membranen verklebt werden. Die dritte Membran kann beispielsweise eine Druckkraft aus dem Pneumatikteil auf eine kleine Wirkfläche konzentrieren.

In einem Ausführungsbeispiel wird im Schritt 302 des Bereitstellens der Fluidikteil und alternativ oder ergänzend der Pneumatikteil mit einer Einrichtung zum Abdichten bereitgestellt, die aus der Fügefläche hervorsteht, wobei die Einrichtung zum Abdichten im Schritt des Verbindens in die erste Membran und alternativ oder ergänzend die zweite Membran gepresst wird, um den Fluidikteil und den Pneumatikteil fluiddicht zu verbinden. Die Einrichtung zum Abdichten kann die Membranen stärker komprimieren, um eine verbesserte Dichtung zu erreichen.

In einem Ausführungsbeispiel werden im Schritt 302 des Bereitstellens der Fluidikteil und der Pneumatikteil mit zumindest zwei Führungselementen bereitgestellt. Im Schritt 306 des Ausrichtens werden der Fluidikteil und der Pneumatikteil unter Verwendung der Führungselemente aneinander ausgerichtet. Führungselemente können Anlageflächen zum Ausrichten der Teile zueinander aufweisen. Die Führungselemente können auch Zentrierhilfen, wie beispielsweise Anschrägungen oder Fasen aufweisen.

In einem Ausführungsbeispiel wird im Schritt 304 des Verschließens die erste Membran an den Führungselementen des Fluidikteils ausgerichtet. Alternativ oder ergänzend wird die zweite Membran an den Führungselementen des Pneumatikteils ausgerichtet. Die Membran kann vor dem Verschließen auf die Führungselemente aufgesteckt werden. Dazu weist die Membran Aufnahmeöffnungen auf, die mit den Führungselementen übereinstimmen.

In einem Ausführungsbeispiel wird im Schritt 306 des Verbindens der Fluidikteil und/oder der Pneumatikteil unter Druck gesetzt werden, um die erste Membran mit der zweiten Membran zu verbinden. Durch den Druck können die Membranen flächig miteinander verbunden werden.

Der hier vorgestellte Ansatz beschreibt eine Vorrichtung und ein Verfahren zum Aufbau von pneumatischen Multilayer Lab-On-Chip (LoC) Kartuschen mit multiplen elastomeren Dichtfolien.

Durch den hier vorgestellten Ansatz ist ein fluidisch leckagefreies Fügen von heterogenen Materialkombinationen bei einer Druckstabilität größer drei bar möglich. Das hier vorgestellte Fügeverfahren ist unabhängig von Oberflächeneigenschaften der eingesetzten heterogenen oder homogenen Materialien. Das hier vorgestellte Fügeverfahren ergibt kontinuierliche und fluidisch dichte Schweißkonturen. Der hier vorgestellten Ansatz ermöglicht eine Modifikation der Diffusions-und Permeationseigenschaften der Layermaterialien vor oder nach dem Aufbau der Kartusche. Der hier vorgestellte Ansatz ermöglicht eine Modifikation der Diffusions-und Permeationseigenschaften der elastischen Membranen. Der hier vorgestellte Ansatz ermöglicht eine Modifikation der Oberflächeneigenschaften der Layermaterialien zur Vermeidung unspezifischer Bindungen biologisch relevanter Substanzen. Der hier vorgestellte Ansatz ermöglicht eine flexible Kombination heterogener Materialien.

Fig. 4 zeigt eine Darstellung eines Führungselements 400 zum Verbinden eines ersten Teils 402 und eines zweiten Teils 404 einer Analysekartusche gemäß einem Ausführungsbeispiel der vorliegenden Erfindung. Erster Teil 402 und zweiter Teil 404 können sowohl den Fluidikteil als auch den Pneumatikteil, wie sie in den Figuren 1 und 2 dargestellt sind, repräsentieren. Dargestellt ist eine exemplarische Darstellung eines Klick-Mechanismus 400 zum dauerhaften Verbinden und Aufrechterhaltung einer mechanischen Pressung zwischen dem Fluidikteil und dem Pneumatikteil. Hierbei können alle Komponenten des Klick-Verschlusses 400 direkt im Herstellungsprozess der Grundsubstrate 402, 404 hergestellt werden. Beispielsweise als Klick-Finger 406 des zweiten Layers 404 im Spritzguss. Der Klick-Finger 406 ist dazu ausgebildet, in einer Haltestruktur 408 des ersten Layers 402 einzurasten. Die Fügung erfolgt dann durch Verpressen des Fluidiklayers mit dem Pneumatiklayer bzw. dem Membran-Stack 410. Der Klick-Mechanismus 400 kann auch multiple Haltenasen 406 und Haltestrukturen 408 aufweisen.

In einer weiteren Ausführungsform werden der Pneumatiklayer und der Fluidiklayer über einen Ratschen-, Schnapp- oder Klickmechanismus 400 zusammengehalten.

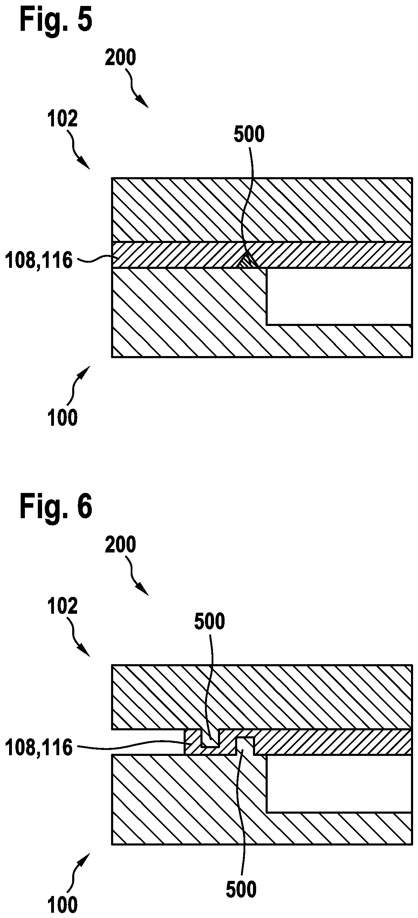

Fig. 5 zeigt eine Darstellung eines Fluidikteils 100 mit einer Einrichtung 500 zum Abdichten einer Analysekartusche 200 gemäß einem Ausführungsbeispiel der vorliegenden Erfindung. Die Einrichtung 500 zum Abdichten ist als vorstehende Struktur aus einer Kontaktfläche zwischen dem Fluidikteil 100 und der ersten Membran 108, wie sie in den Figuren 1 und 2 dargestellt ist, ausgeführt. Die Einrichtung 500 zum Abdichten kann als Dichtlippe 500 bezeichnet werden. Die erste Membran 108 und die zweite Membran 116 sind zwischen dem Fluidikteil 100 und dem Pneumatikteil 102 angeordnet. Die Einrichtung 500 zum Abdichten verengt lokal einen Abstand zwischen dem Fluidikteil 100 und dem Pneumatikteil 102. Dadurch werden im Bereich der Dichtlippe 500 die erste Membran 108 und die zweite Membran 116 gequetscht und eine erhöhte Dichtwirkung erreicht.

In einem Ausführungsbeispiel wird die Dichtlippe 500 erst bei einer geplanten Verwendung der Analysekartusche 200 in einem Analysegerät durch einen von dem Analysegerät auf die Analysekartusche 200 ausgeübten Druck in die Membranen 108, 116 gedrückt, um eine Abdichtung zu verbessern.

Fig. 6 zeigt eine Darstellung eines Fluidikteils 100 und eines Pneumatikteils 102 mit je einer Einrichtung 500 zum Abdichten einer Analysekartusche 200 gemäß einem Ausführungsbeispiel der vorliegenden Erfindung. Wie in Fig. 5 sind die Einrichtungen 500 als vorstehende Strukturen ausgebildet. Die Einrichtungen 500 sind seitlich zueinander versetzt angeordnet. Die Einrichtungen können auch einander gegenüberstehend angeordnet sein, um die Quetschung der beiden Membranen 108, 116 zu erhöhen.

Zur besseren Abdichtung ist im Pneumatiklayer 102 und/oder Fluidiklayer 100 eine Dichtlippe 500 integriert, welche die elastische Membranen 108, 116 zusätzlich komprimiert. In Fig. 5 ist die Dichtlippe 500 dreieckförmig. In Fig. 6 sind komplementäre Dichtlippen 500 im Pneumatiklayer 102 und Fluidiklayer 100 versetzt angeordnet. In einem Ausführungsbeispiel sind die elastischen Membranen 108, 116 strukturiert ausgeführt.

In einer Ausführungsform ist das fluidische Netzwerk von Dichtlippen 500 umgeben, welche sich beim Fügen in die elastische Membran 108, 116 pressen und die Abdichtung verstärken.

In einer weiteren Ausführungsform weist der Pneumatiklayer 112 und/oder der Fluidiklayer 104 eine Erhöhung 500 auf, welche die fluidischen Strukturen 106 umfasst und als Dichtlippe 500 wirkt. Die Dichtlippe 500 taucht in die elastische Membran 108, 116 ein und komprimiert bzw. verdrängt diese und sorgt somit für eine erhöhte Dichtung. Die Dichtlippe 500 hat typischerweise eine Höhe kleiner 80% der Dicke der elastischen Membran 108, 116, typischerweise zuwischen 10 µm und 100 µm Höhe und Breite. Ferner können sowohl Fluidik- wie auch Pneumatiklayer 104, 112 komplementäre Dichtlippen 500 aufweisen, die aufeinander zeigen oder versetzt zueinander sind. In einer weiteren Ausführungsform wird die elastische Membran 108, 116 z. B. um komplementäre und leicht versetzte Dichtlippen 500 aus Pneumatik- und Fluidiklayer 104, 112 gefaltet. Die Dichtlippe 500 kann beliebige Querschnittsgeometrien aufweisen, z. B. Rechteck, Dreieck oder verrundet.

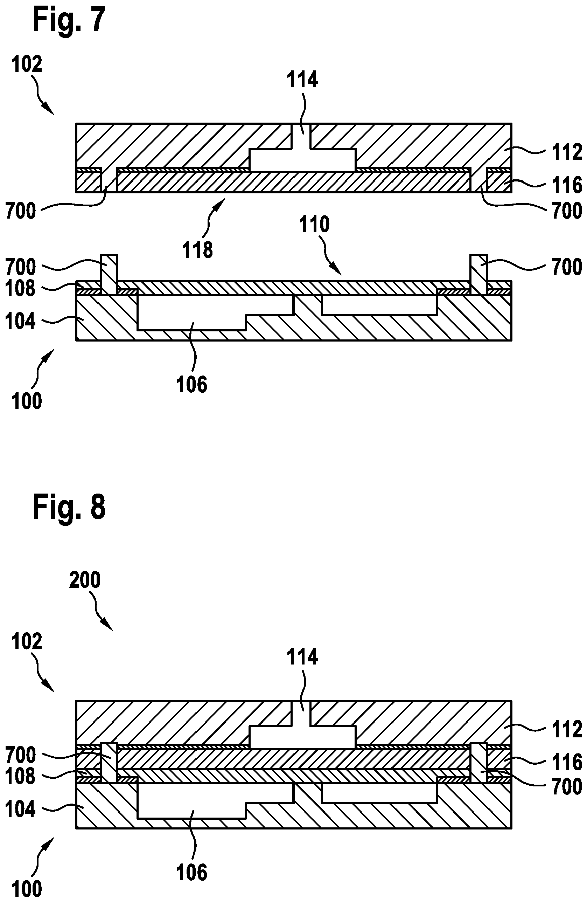

Fig. 7 zeigt eine Darstellung eines Fluidikteils 100 und eines Pneumatikteils 102 mit Führungselementen 700 gemäß einem Ausführungsbeispiel der vorliegenden Erfindung. Der Fluidikteil 100 und der Pneumatikteil 102 entsprechen der Darstellung in den Figuren 1 und 2. Zusätzlich weist der Fluidikteil 100 zwei Passstifte 700 als Führungselemente auf. Die Passstifte 700 stehen senkrecht zu der ersten Fügefläche 110 aus dem ersten Substrat 104 und der ersten Membran 108 hervor. Der Pneumatikteil 102 weist zwei, zu den Passstiften 700 passende Bohrungen 700 als Führungselemente auf. Die Bohrungen 700 oder Aussparungen durchdringen die zweite Membran 116 und enden als Sacklöcher im zweiten Substrat 112.

In einem Ausführungsbeispiel wird der Fluidiklayer 104 analog zum Pneumatiklayer 112 mit einer elastischen Membran 108 mittels Laserschweißen gefügt. Anschließend werden der Pneumatiklayer-Stack 102 und der Fluidiklayer-Stack 100 durch eine mechanische Pressung miteinander gefügt, sodass die beiden elastischen Membranen 108, 116 miteinander in Kontakt sind. Die Stacks 100, 102 werden vor dem Fügen oder während des Fügeprozesses z. B. durch integrierte Passstifte 700 zueinander ausgerichtet. Für das Fügen kommen diverse Verfahren zum Einsatz. Beispielsweise mechanische Pressungen, adhäsive Bonds, Klickmechanismen, verstemmen, laminieren (evtl. mit Temperatur) oder Laserschweißungen.

Fig. 8 zeigt eine Darstellung einer Analysekartusche 200 mit Führungselementen 700 gemäß einem Ausführungsbeispiel der vorliegenden Erfindung. Die Analysekartusche 200 entspricht der Darstellung in Fig. 2 und ist aus dem Fluidikteil 100 und dem Pneumatikteil 102 mit den dazwischen angeordneten Membranen 108, 116. Die Passstifte 700 sind in den Sacklöchern 700 angeordnet und definieren eine Lage der Teile 100, 102 in Bezug zueinander.

In einem Ausführungsbeispiel ist die LoC-Kartusche 200 aus zwei Stacks 100, 102 aufgebaut. Jeder Stack 100, 102 besteht aus einem Substrat 104, 112 mit fluidischen Strukturen 106, 114 und einer mittels Laserschweißen gefügten elastischen Membran 108, 116. Substrate 104, 112 und Membranen 108, 116 können jeweils aus unterschiedlichen Materialien realisiert sein. Das Alignment erfolgt durch integrierte Passstifte 700 in einem Substrat 104 und entsprechenden Aussparungen 700 im Gegenstück 112. Die Stacks 100, 102 werden durch eine mechanische Pressung, wie einen adhäsiven Bond oder Passstifte 700 mit Klick-Mechanismen gefügt. Im dargestellten Ausführungsbeispiel sind der Fluidikteil 100 und der Pneumatikteil 102 über eine adhäsive Fügung verbunden.

In einer Ausführungsform werden verschiedene Fügeverfahren kombiniert. Insbesondere für die Realisierung der mechanischen Pressung können z. B. Fügestifte 700 mit Ratschen- oder multiplen Klemm- oder Klickstrukturen kombiniert werden. Ebenfalls können zwei Layer über adhäsives Fügen verbunden werden, wobei Fügestifte 700 als Passstifte für ein präzises Alignment eingesetzt werden, ohne die adhäsive Fügung zu verstärken.

In einer Ausführungsform werden die hier beschriebenen Fügeverfahren lediglich zur Herstellung einer mechanischen Verbindung und Ausrichtung der Komponenten genutzt. Die zur vollständigen Abdichtung der Kartusche notwendigen Kräfte werden erst mit dem Einlegen der Kartusche 200 in die Auswerteeinheit (DxU) angelegt. Hierdurch werden mögliche Relaxationen der Fügeverbindung bei Langzeitlagerung wirksam verhindert.

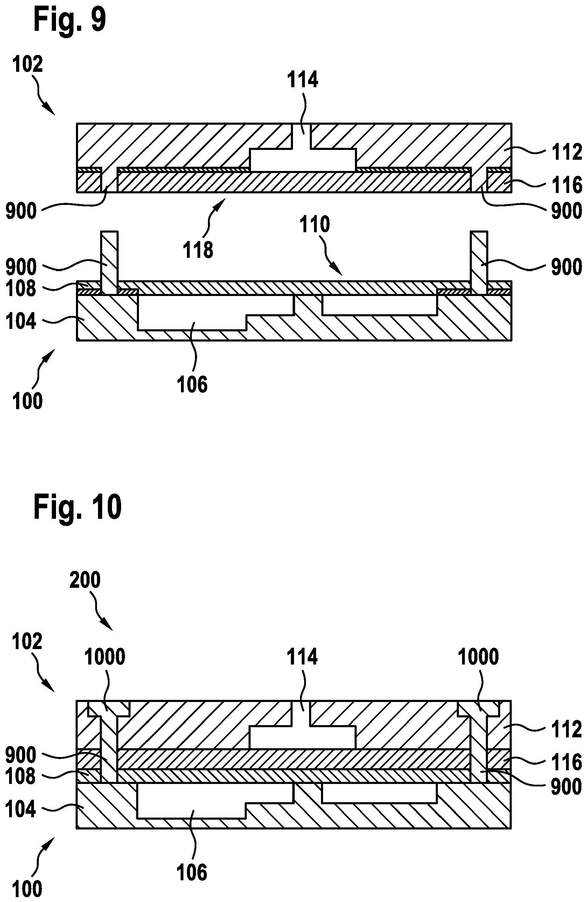

Fig. 9 zeigt eine Darstellung eines Fluidikteils 100 und eines Pneumatikteils 102 mit Verbindungselementen 900 gemäß einem Ausführungsbeispiel der vorliegenden Erfindung. Der Fluidikteil 100 und der Pneumatikteil 102 entsprechen dem in Fig. 7 gezeigten Ausführungsbeispiel. Im Gegensatz dazu sind die Führungselemente als Verbindungselemente 900 ausgebildet. Die Verbindungselemente 900 sind an dem Fluidikteil 100 als Bolzen ausgeführt, die dazu ausgebildet sind, eine Führungsfunktion zu erfüllen. Die Bolzen 900 sind länger als die Passstifte in Fig. 7. Die Verbindungselemente 900 sind im Pneumatikteil 102 als Durchgangslöcher von der Fügefläche 118 bis zu einer Rückseite des Pneumatikteils 102 ausgeführt. Die Bolzen 900 sind so lang, dass sie durch die Durchgangslöcher 900 bis zu der Rückseite reichen und dort befestigt werden können. Die Bolzen 900 und die Durchgangslöcher 900 sind zueinander passend ausgeführt.

Fig. 10 zeigt eine Darstellung einer Analysekartusche 200 mit Verbindungselementen 900 gemäß einem Ausführungsbeispiel der vorliegenden Erfindung. Die Analysekartusche 200 entspricht dem in Fig. 8 dargestellten Ausführungsbeispiel. Im Gegensatz dazu sind die Führungselemente wie in Fig. 9 als Verbindungselemente 900 ausgeführt. Die Bolzen 900 sind in den Durchgangslöchern 900 angeordnet und weisen an der Rückseite des Pneumatikteils 102 je eine Verdickung 1000 zum formschlüssigen Verbinden auf. Die Verdickungen 1000 weisen größere Abmessungen auf, als die Durchgangsbohrungen 900. Die Verdickungen 1000 können umgeformtes Material der Bolzen 900 sein. Dann kann der Fluidteil 100 mit dem Pneumatikteil 102 zusammengenietet sein. Ebenso können die Bolzen 900 Gewinde aufweisen und die Verdickungen 1000 können als Muttern oder Schrauben ausgeführt sein.

In einem Ausführungsbeispiel ist der Aufbau der LoC-Kartusche 200 aus zwei Stacks 100, 102. Jeder Stack 100, 102 besteht aus einem Substrat 104, 112 mit fluidischen Strukturen 106, 114 und einer mittels Laserschweißen gefügten elastischen Membran 108, 116. Substrate 104, 112 und Membranen 108, 116 können jeweils aus unterschiedlichen Materialien realisiert sein. Das Alignment erfolgt durch integrierte Passstifte 900 in einem Substrat 104 und entsprechenden Aussparungen 900 im Gegenstück 112. Die Stacks 100, 102 werden durch eine mechanische Pressung, z. B. Nieten 1000 gefügt. Die Membranen 108, 116 sind nicht miteinander verbunden. Das bedeutet, eine erste Membran 108 kann nur bei Auslenkung mittels Überdruck die Deformation an die zweite Membran 116 weitergeben und nicht bei Unterdruck.

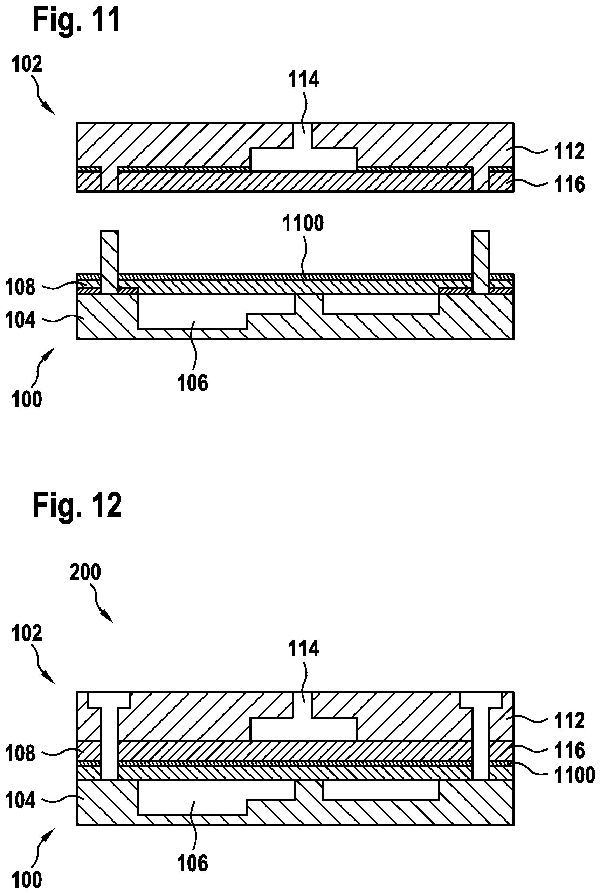

Fig. 11 zeigt eine Darstellung eines Fluidikteils 100 mit beschichteter Membran 108 gemäß einem Ausführungsbeispiel der vorliegenden Erfindung. Ferner ist ein Pneumatikteil 102 dargestellt. Der Fluidikteil 100 und der Pneumatikteil 102 entsprechen der Darstellung in den Figuren 9 und 10. Zusätzlich ist die erste Membran 108 beschichtet ausgeführt, um Diffusionseigenschaften und/oder Permeabilitätseigenschaften der ersten Membran 108 zu verändern.

Fig. 12 zeigt eine Darstellung einer Analysekartusche 200 mit beschichteter Membran 108 gemäß einem Ausführungsbeispiel der vorliegenden Erfindung. Die Analysekartusche 200 entspricht der Analysekartusche in Fig. 10. Zusätzlich ist die erste Membran 108 des Fluidikteils 100 wie in Fig. 11 beschichtet.

Die Oberfläche der Membran 108, welche nicht lasergeschweißt wird, ist modifiziert. Beispielsweise ist eine Metallschicht 1100 als Difusionsbarriere auf der Membran 108 angeordnet. Diese kann auch als Fügeschicht der beiden 2-Layer-Stacks 100, 102 dienen oder teilweise vergraben sein, wobei eine weitere Fügefläche außerhalb der Beschichtung 1100 zum Tragen kommt.

In einer Ausführungsform sind die Diffusions- bzw. Permeationseigenschaften der Membran 108, 116 optimiert. Hierzu wird die Oberfläche der elastischen Membran 108, 116 eines Stacks 100, 102, welche später mit dem zweiten Stack 100, 102 gefügt wird, beschichtet. Besonders geeignet sind metallische Schichten wie Aluminium oder fluorbasierte Schichten wie Teflon. Werden die beiden Zweilayerstacks 100, 102 gefügt, so wird die aufgebrachte Schicht z. B. als Diffusionsbarriere zwischen den beiden Membranen 108, 116 vergraben. Somit kann z. B. Gasdiffusion aus dem Fluidiklayer 100 in den Pneumatiklayer 102 oder in die Umwelt unterbunden werden. Vorteil ist hierbei, dass das Diffusionsmaterial, was oft nicht biokompatibel ist, überhaupt nicht mit dem fluidischen Netzwerk in Kontakt kommt.

In einem Ausführungsbeispiel wird ein weiteres elastisches Material 1100 zwischen die beiden Stacks 100, 102 eingebracht. Es können unterschiedliche elastische Membranen 1100 mit unterschiedlichen Geometrien (z. B. Dicken, Aussparungen, Außenabmessungen, Formen) für die Stacks 100, 102 eingesetzt werden.

In einer Ausführungsform sind die Oberflächen der elastischen Membran 108, 116 und/oder die Oberflächen des Fluidiklayers 104 oder zumindest die der fluidischen Strukturen 106 im Fluidiklayer 104 beschichtet. Die Beschichtung kann z. B. unspezifische Bindungen von Enzymen, DNA-Strängen, RNA-Strängen, Nukleotiden oder Proteine wie Polymerasen, Ligasen oder Antikörper vermeiden. Die Beschichtung kann z. B. Diffusions- oder Permeationseigenschaften der Membran 108, 116 verändern. Mögliche Beschichtungen sind Parylen, PEG, Hydrogele, Fluorierungen insbesondere PTFE Beschichtung, Siliziumoxid oder Glas. Die Beschichtung kann flächig oder selektiv strukturiert vor dem Fügen erfolgen. Es ist auch möglich unterschiedliche Bereiche mit unterschiedlichen Materialien zu beschichten. Auch physikalische Modifikationen, wie Plasmabehandlungen oder Implantation von Stoffen sind einsetzbar. Ferner kann die Oberflächenmodifikation auch nach dem Fügen durchgeführt werden.

Ferner kann die Oberflächenmodifikation dazu dienen, die Diffusion und Permeation von Gasen und Flüssigkeiten drastisch zu reduzieren, sodass die Lagerung von Flüssigkeiten wie Puffer (z. B. Waschpuffer, Hybridisierungspuffer, Lysepuffer), Ethanollösungen, PCR-Mastermix mit DNA-Lösungen, RNA-Lösungen, Enzymlösungen, Proteinlösungen, Nukleotidlösungen über einen längeren Zeitraum (größer 1/2 Jahr) möglich ist. Mögliche Beispiele für Beschichtungen sind hier beispielsweise Glas, Siliziumoxid oder Aluminium.

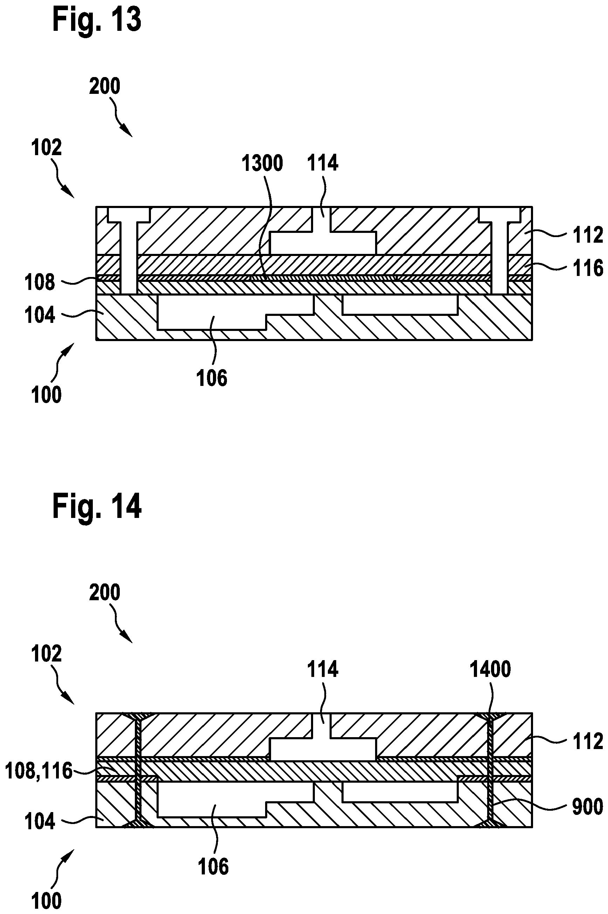

Fig. 13 zeigt eine Darstellung einer Analysekartusche 200 mit teilweise beschichteter Membran 108 gemäß einem Ausführungsbeispiel der vorliegenden Erfindung. Die Analysekartusche 200 entspricht der Analysekartusche in Fig. 12. Im Gegensatz dazu ist die erste Membran 108 des Fluidikteils 100 nur partiell beschichtet. Eine verbleibende Restfläche der Membran 108 ist unbeschichtet.

In einer Ausführungsform werden die Membranen 108, 116 mittels selektivem adhäsivem Bond 1300 gefügt. Der adhäsive Bond 1300 erstreckt sich auf bestimmte Teilflächen der Membranen 108, 116. Der Fluidikteil 100 und der Pneumatikteil sind mit Fügestiften 700 zum Verpressen der beiden Stacks 100, 102 verbunden. Die Auslenkung der Membran 116 des Pneumatikstacks 102 durch Anlegen eines Überdruckes wird direkt an die Membran 108 des Fluidikstacks 100 weitergegeben/übertragen, wodurch diese ebenfalls ausgelenkt wird. Hiermit lassen sich aktive fluidische Elemente realisieren, wie mit rein durch Laserschweißen aufgebauten Kartuschen. Falls die elastischen Membranen 108, 116 auch angesaugt werden sollen, d. h. über eine Aktuierung durch Anlegen eines Vakuums an den Pneumatikstack 102, so können beiden Membranen 108, 116 fest miteinander verbunden werden, z. B. mittels Kleben, thermischem Fügen oder adhäsiver Schichten 1300. Die feste Fügung der elastischen Membran 108, 116 kann flächig oder strukturiert bzw. lokalisiert auf bestimmten Positionen bzw. Teilflächen erfolgen. Um die Diffusions- bzw. Permeationseigenschaften der Membran 108, 116 zu verändern, kann die Oberfläche der elastischen Membran 108, 112 eines Stacks100, 102, welche später mit dem zweiten Stack 100, 102 gefügt wird beschichtet werden.

Aufgrund der Kompatibilität der Membranoberfläche zum Prozess des Laserschweißens ist eine Oberflächenmodifikation der Laserfügefläche 110, 118 nicht möglich. Da die der Laserfügefläche 110, 118 entgegengesetzte Membranoberfläche im Zweimembranenaufbau zugänglich wird, können negative Membraneigenschaften zusätzlich modifiziert werden.

Fig. 14 zeigt eine Darstellung einer Analysekartusche 200 mit Niete 1400 gemäß einem Ausführungsbeispiel der vorliegenden Erfindung. Die Analysekartusche 200 entspricht der Analysekartusche in Fig. 10. Im Gegensatz dazu weist der Fluidikteil 100 Durchgangsbohrungen 900, wie der Pneumatikteil 102 auf. In den Durchgangsbohrungen 900 sind die Niete 1400 angeordnet, die von der Rückseite des Fluidikteils 100 bis zu der Rückseite des Pneumatikteils 102 reichen, um die Analysekartusche 200 mechanisch vorzuspannen. Die Niete 1400 sind bündig zu den Rückseiten ausgeführt und weisen je einen kegelförmigen Kopf am Ende auf.

In einem Ausführungsbeispiel sind die Membranen 108, 116 durch eine Laserschweißung und eine mechanische Pressung verbunden.

In einem Ausführungsbeispiel ist eine Schnittansicht einer aufgebauten LoC-Kartusche 200 bestehend aus vier Layern 104, 108, 112, 116 gezeigt. Die Pressung wird mittels Nieten (Fügetechnik) realisiert. In dem Pneumatikteil 102 ist ein Pneumatikkanal integriert.

Die mechanische Pressung kann hierbei an multiplen diskreten Positionen erfolgen, wobei die mikrofluidischen Strukturen 106 flächig in einem Chip abgedichtet werden. In einer Ausführungsform weisen die Layer Durchlöcher 900 auf, wodurch eine Fügung z. B. durch Nieten 1400 insbesondere Kunststoffnieten realisiert werden kann. Alternativ können auch Schrauben oder ähnliche Verbindungsmethoden eingesetzt werden.

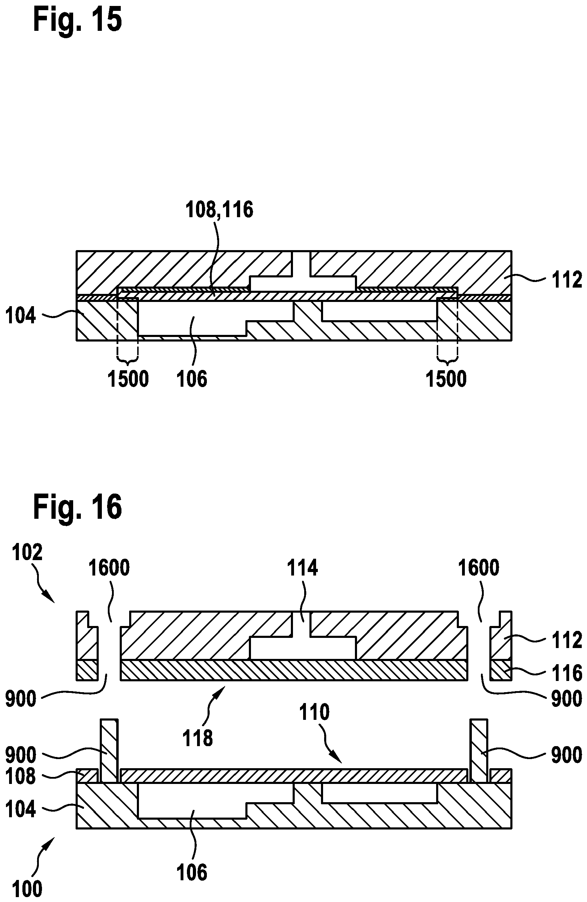

Fig. 15 zeigt eine Darstellung einer Analysekartusche 200 mit Dichtrand 1500 gemäß einem Ausführungsbeispiel der vorliegenden Erfindung. Die Analysekartusche 200 entspricht der Darstellung in Fig. 2. Im Gegensatz zu Fig. 2 erstrecken sich die Membranen 108, 116 nur teilflächig über das erste Substrat 104 und das zweite Substrat 112. Die Membranen 108, 116 sind in dem Dichtrand 1500 beidseitig durch die Substrate 104, 112 geklemmt. Außerhalb des Bereichs der Membranen 108, 116 sind die Substrate 104, 112 unmittelbar miteinander verbunden.

In einem Ausführungsbeispiel erfolgt die Flächenfügung direkt zwischen dem Pneumatik 102 und Fluidiklayer 100, beispielsweise durch thermisches Bonden, Ultraschallbonden oder Laserschweißen. Die elastische Membran 108, 116 ist strukturiert, um eine Bondfläche 1500 zwischen Pneumatik 102 und Fluidiklayer 100 freizulegen. Ferner ist die elastische Membran 108, 116 exemplarisch in den Pneumatik 102 und Fluidiklayer 100 versenkt. Die Membran 108, 116 steht über das fluidische Netzwerk 106 hinaus und wird zwischen Pneumatik 102 und Fluidiklayer 100 geklemmt, wodurch sie als "Dichtring" fungiert.

In einer Ausführungsform werden für das Zusammenführen des Fluidiklayers 104 mit dem Multilayeraufbau bestehend aus Pneumatiksubstrat 112 und elastischer Membran 108, 116 heterogene Materialien eingesetzt. Die Fügung erfolgt durch eine mechanische Pressung bzw. Verbindung des Fluidiksubstrates 104 an die elastische Membran 108 bzw. den Pneumatiklayer 112 als kraftschlüssiger Dichtungsaufbau. Dies erfolgt, indem der Fluidiklayer 104 mit dem verschweißten Pneumatiklayer 102 und der elastischen Membran 108 zusammengebracht wird, diese zusammengepresst werden und diese Pressung über ein Verfahren langzeitstabil aufrechterhalten wird. Die elastische Membran 108 dient hierbei als Dichtmaterial für die Strukturen 106 im Fluidiklayer 104. Hierbei kann die elastische Membran 108 als Flächendichtung eingesetzt werden, oder so strukturiert werden, dass sie den Randbereich 1500 der fluidischen Strukturen 106 überlappt und somit die fluidischen Strukturen 106 wie ein "Dichtring" abdichtet. Die elastische Membran 108 kann hierbei komplett zwischen dem Pneumatik- und Fluidiklayer 104, 112 integriert sein oder in einem Substrat 104, 112 oder beiden Substraten leicht versenkt werden. Bei der mechanischen Pressung kann das elastische Material komprimiert oder gequetscht werden. Die Pressung ist so stark, dass keine relevante gas- oder fluidische Leckage der mikrofluidischen Strukturen 106 auftreten.

In einer Ausführungsform werden neben diskreten Fügepunkten auch lineare oder flächige Pressungen eingesetzt. So kann z. B. die elastische Membran 108, 116 ausgeschnitten werden und die beiden Pneumatik- und Fluidiklayer 104, 112 werden mittels Ultraschallbonden gefügt. Hierbei findet der Energieeintrag typischerweise über Energieabnehmer statt, die die fluidischen Strukturen 106 umschließen. Falls die Materialkombinationen es ermöglichen, kann auch direkt ein Bond zwischen Fluidik und elastischer Membran 108, 116 hergestellt werden. Ferner sind auch adhäsive Fügeverfahren möglich oder Fügeverfahren mit Temperatureinkopplung, wie thermisches Bonden, Vibrationsbonden, thermisches Verstemmen oder Heizelementeschweißen. Der Bond kann je nach Ausführungsform zwischen dem Fluidiklayer 104 und der elastischen Membran 108 oder dem Fluidiklayer 104 und dem Pneumatiklayer 112 erfolgen. Im zweiten Fall ist die elastische Membran 108, 116 so strukturiert, dass ein Kontakt zwischen Pneumatik- und Fluidiklayer ermöglicht wird.

In einer Ausführungsform wird der Pneumatik- und Fluidiklayer 104, 112 mit ausgeschnittener und integrierter elastomeren Membran 108, 116 auch über Laserschweißung gefügt. Hierbei können ebenfalls diskrete Flächen, Konturen z. B. der fluidischen Strukturen 106 oder die gesamte Kontaktfläche miteinander gefügt werden.

Fig. 16 zeigt eine Darstellung eines Fluidikteils 100 und eines Pneumatikteils 102 mit Verbindungselementen 900 vor dem Ausrichten gemäß einem Ausführungsbeispiel der vorliegenden Erfindung. Das Fluidikteil 100 und das Pneumatikteil 102 entsprechen der Darstellung in Fig. 9. Das Fluidikteil 100 weist das erste Substrat 104 mit der ersten Struktur 106 und die erste Membran 108 auf. Die erste Membran ist auf der ersten Fügefläche 110 angeordnet und verschließt die erste Struktur 106 fluiddicht. Die erste Struktur 106 kann als Fluidik bezeichnet werden. Der Fluidikteil 100 weist als Verbindungselemente 900 Zapfen auf, die über die erste Fügefläche 110 und die erste Membran 108 überstehen. Der Pneumatikteil 102 weist das zweite Substrat 112 mit der zweiten Struktur 114 und die zweite Membran 116 auf. Die zweite Membran 116 ist auf der zweiten Fügefläche 118 angeordnet und verschließt die zweite Struktur 114. Die zweite Struktur 114 kann als Pneumatik oder Pneumatikkanal bezeichnet werden. Der Pneumatikteil 102 weist als Verbindungselemente 900 Durchgangslöcher 900 auf, die passend zu den Zapfen 900 angeordnet sind. Zusätzlich weist das Pneumatikteil 102 auf der, der zweiten Fügefläche 118 gegenüberliegenden Rückseite Aussparungen 1600 auf, die konzentrisch zu den Durchgangslöchern 900 angeordnet sind.

Ein Trägersubstrat 104, 112, welches pneumatische oder hydraulische Kanäle 106, 114 beinhaltet, wird mit einer strukturierten elastischen Membran 108, 116 über Laserschweißen selektiv gefügt. Als Substrate 104, 112 des Pneumatiklayers 102, wie auch des späteren Fluidiklayers 100 können Thermoplaste, wie COP, COC, PC, PA, PU, PP, PE, PET oder PMMA verwendet werden. Als elastische Membran 108, 116 können Elastomere oder thermoplastische Elastomere, wie thermoplastische Elastomere auf Olefinbasis, vernetzte thermoplastische Elastomere auf Olefinbasis, thermoplastische Elastomere auf Urethanbasis, thermoplastische Polyesterelastomere / thermoplastische Copolyester, thermoplastische Elastomere auf Styrolbasis, thermoplastische Copolyamide, thermoplastische Elastomere auf Polyether-Basis, thermoplastische Elastomere auf Polyethylen Basis oder TPS, wie Styrol-Blockcopolymere oder Styrol-Blockpolymere eventuell mit Ethylen-Butylen, eingesetzt werden. Auch Kombinationen mit weiteren Materialien sind möglich. Alternativ oder ergänzend können auch elastische Mehrschichtfolien oder Verbundfolien mit einer laserschweißbaren Oberfläche zum Pneumatiksubstrat eingesetzt werden. Eine weitere Alternative sind plastisch verformbare Monofolien aus den oben genannten thermoplastischen Materialien. Die elastischen Membranen 108, 116 werden in einem Ausführungsbeispiel mittels Stanzen oder Laserablation strukturiert. Danach werden der Pneumatiklayer 102 bzw. der Fluidiklayer 102 und die elastische Membran 116 bzw. 108 unter Druck in Kontakt gebracht (p < 3 bar, F < 5 kN) und mittels Laserschweißen gefügt. Typischerweise werden Laser im IR-Bereich eingesetzt insbesondere bei Wellenlängen um 1064 nm. Hierbei wirkt entweder das Pneumatiksubstrat 112 oder die elastische Membran 116 oder Beide als Absorber für die laserinduzierte Energie. Die Laserenergie wird hierbei durch das für die Wellenlänge des Laserlichts transparente Material auf die Grenzfläche der beiden Layer eingekoppelt. Alternativ kann das Laserlicht auch auf die Rückseite eines Absorbers eingekoppelt werden, wobei die Wärme an die Grenzfläche der Materialien weitergeleitet wird, um eine Schweißung zu erreichen. Die Schweißung erfolgt hierbei selektiv auf definierten Flächen bzw. selektiv auf definierten Schweißbahnen, sodass nach dem Fügeprozess Flächen vorhanden sind, wo die elastische Membran 108, 116 und das Pneumatiksubstrat 112 bzw. das Fluidiksubstrat 102 nicht miteinander verbunden sind.

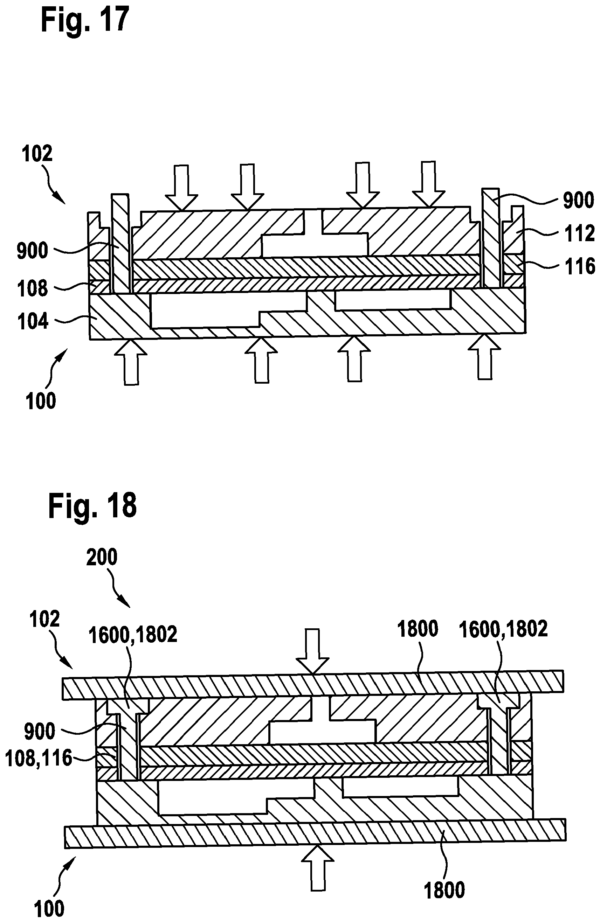

Fig. 17 zeigt eine Darstellung eines Fluidikteils 100 und eines Pneumatikteils 102 mit Führungselementen 900 während des Ausrichtens gemäß einem Ausführungsbeispiel der vorliegenden Erfindung. Der Fluidikteil 100 und der Pneumatikteil 102 entsprechen der Darstellung in Fig. 16. Die Zapfen 900 sind in den Durchgangslöchern 900 angeordnet und die erste Membran 108 liegt an der zweiten Membran 116 an. Durch die Zapfen 900 in den Löchern 900 werden der Fluidikteil 100 und der Pneumatikteil 102 aneinander ausgerichtet und in einer vorbestimmten Relativposition zueinander gehalten. Beim Ausrichten wird auf die Rückseite des Fluidikteils 100 und die Rückseite des Pneumatikteils 102 Druck ausgeübt, um die Membranen 108, 116 aneinander zu pressen. Dabei können die Membranen 108, 116 miteinander verbunden werden. Die Zapfen 900 durchdringen die Durchgangslöcher 900 und stehen über die Rückseite des Pneumatikteils 102 über.

Fig. 18 zeigt eine Darstellung eines Fluidikteils 100 und eines Pneumatikteils 102 mit Führungselementen 900 während des Verbindens gemäß einem Ausführungsbeispiel der vorliegenden Erfindung. Der Fluidikteil 100 und der Pneumatikteil 102 sind wie in Fig. 17 aneinander ausgerichtet und die erste Membran 108 liegt an der zweiten Membran 116 an. An den Rückseiten des Fluidikteils 100 und des Pneumatikteils 102 liegen Druckplatten 1800 einer Einrichtung zum Verbinden mit Druck an. Zumindest die Druckplatte 1800, die an dem Pneumatikteil 102 anliegt, ist beheizt. Durch die Temperatur der Druckplatte 1800 sind die über die Rückseite überstehenden Bestandteile der Zapfen 900 aufgeschmolzen worden und durch den Druck in die Aussparungen 1600 hinein umgeformt worden. Die Zapfen 900 sind jetzt abgeflacht und weisen tellerartige Verbreiterungen 1802 auf, die sich in den Aussparungen 1600 verhaken. Durch die Verbreiterungen ist der Fluidikteil 100 fest mit dem Pneumatikteil 102 zu der Analysekartusche 200 verbunden.

In den Figuren 16 bis 18 ist ein Ausführungsbeispiel eines Fügeprozesses mittels integrierter Fügestifte 900 dargestellt. Die Fügestifte 900 können im Herstellungsprozess (z. B. Spritzguss) des zugehörigen Layers 100 realisiert werden. Die weiteren Layer 102, 108, 116 weisen entsprechende Durchlöcher 900 auf. Unter Druck werden die Layer 100, 102, 108, 116 gegeneinander verpresst. Das Verpressen kann unter Vakuum durchgeführt werden. Die Fügestifte 900 werden aufgeschmolzen und in spezielle Aussparungen 1600 des Haltelayer 102 eingedrückt, sodass die Oberfläche keine Erhöhung aufweist. Die Fügeteller 1800 in der Fügebucht 1600 halten die während der Fertigung aufgebrachte mechanische Pressung aufrecht, sodass abgedichtete fluidischen Netzwerke 106 realisiert werden. Je nach Prozess kann das Ausrichten und Verbinden auch in einem Schritt realisiert werden.

Mit anderen Worten zeigen die Figuren 16, 17 und 18 ein Ausführungsbeispiel eines mechanischen Fügens von Multilayer LoC Kartuschen 200 mit elastomeren Dichtfolien 108, 116.

Es können auch Fügemethoden bei erhöhter Temperatur eingesetzt werden. So können Beispielsweise Stifte 900 normal zur Ebene direkt im Spritzguss eines Pneumatik- und/oder Fluidiklayers 104, 112 realisiert werden. Die elastische Membran 108, 116, wie auch das Gegenstück des Pneumatiklayers oder Fluidiklayers weist Durchlöcher 900 auf. Die Layer werden zusammengepresst, wodurch die Stifte 900 aus dem Gegenstück herausragen. Anschließend werden diese thermisch (über der Glasübergangstemperatur des Materials) aufgewärmt, sodass das Material fließen kann und sich so unter Anlegen einer Kraft verformt, sodass sich eine dauerhafte Pressung ergibt. Typischerweise werden die Verbindungen so eingebracht, dass die äußeren Oberflächen des Aufbaus 200 planar sind und keine Erhebungen aufweisen. Hierfür weist das Gegenstück typischerweise eine Vertiefung 1600 auf. Über den Anpressdruck/-kraft oder weggesteuerte Prozesskontrolle können die Bondkräfte variabel eingestellt werden.

In einer weiteren Ausführungsform sind die Fügestifte 900 so ausgelegt, dass sie im Gegensubstrat als Passstifte wirken und beim Fügen die Layer zueinander ausgerichtet und justiert werden. Eine Alternative ist, dass nur ein Teilbereich des Führungsstiftes 900 als Passstift ausgelegt ist (z. B. der untere Teil) und ein anderer Teil flexibel gestaltet ist, um z. B. das "Einfädeln" der Substrate zu vereinfachen (oberer Teil).

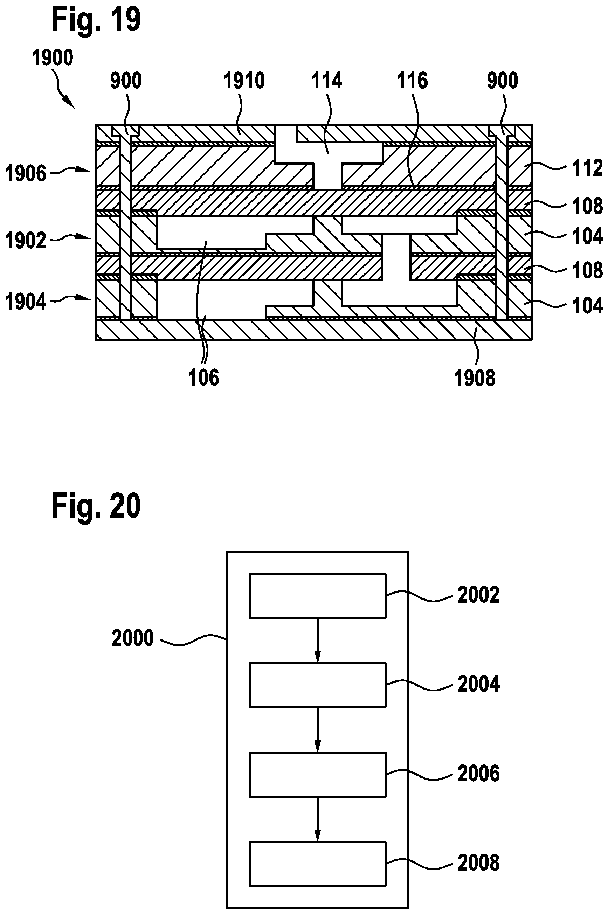

Fig. 19 zeigt eine Darstellung einer Analysekartusche 1900 mit einem ersten Fluidikteil 1902 und einem zweiten Fluidikteil 1904 gemäß einem Ausführungsbeispiel der vorliegenden Erfindung. Die Analysekartusche 1900 weist ferner einen Pneumatikteil 1906 auf. Die Fluidikteile 1902, 1904 sind ähnlich aufgebaut. Jeder der Fluidikteile 1902, 1904 weist wie der Fluidikteil in den Figuren 1 bis 18 ein erstes Substrat 104 und eine erste Membran 108 auf. Der Pneumatikteil 1906 weist wie der Pneumatikteil in den Figuren 1 bis 18 ein zweites Substrat 112 und eine zweite Membran 116 auf. Das erste Fluidikteil 1902 ist auf dem zweiten Fluidikteil 1904 angeordnet. Der Pneumatikteil 1906 ist auf dem ersten Fluidikteil 1902 angeordnet. Die Fluidikteile 1902, 1904 und der Pneumatikteil 1906 bilden einen Stapel. Der Stapel weist eine abschließende Bodenplatte 1908 und eine abschließende Deckplatte 1910 auf. Die erste Membran des zweiten Fluidikteils 1904 weist eine Öffnung auf. Fluidkanäle 106 in den Fluidikteilen 1902, 1904 sind über die Öffnung in der ersten Membran 108 fluidisch verbunden. Der Pneumatikteil 1906 weist Pneumatikkanäle 114 auf. Die Pneumatikkanäle 114 sind durch die erste und zweite Membran 108, 116 von den Fluidkanälen 106 getrennt. Der Stapel ist wie in Fig. 18 durch Verbindungselemente 900 verbunden. Die Verbindungselemente 900 verbinden die Bodenplatte 1908 und die Deckplatte 1910 mechanisch miteinander und richten die Fluidikteile 1902, 1904 und den Pneumatikteil 1906 zueinander aus. Die Verbindungselemente 900 durchdringen die die Fluidikteile 1902, 1904 und den Pneumatikteil 1906.

In einem Ausführungsbeispiel ist die Analysekartusche 1900 ein Multilagenaufbau, bei dem mehrere Layer 1902, 1904, 1906 mechanisch gepresst gefügt werden oder auch über mehrere Laserschweißebenen verbunden sind. Ein Layer kann hierbei aus Kombination von Laserschweißung und mechanischer Pressung oder jeweils über nur eines der Fügeverfahren abgedichtet sein. Für die mechanische Pressung können beliebige Fügeverfahren (z. B. auch adhäsive) eingesetzt werden.

In einer weiteren Ausführungsform werden periodisch über weitere mechanische Pressungen oder Laserschweißprozesse weitere Lagen aufgebracht, um Multilayersysteme mit mehr als vier Layer herzustellen. Ferner können auch auf den Vierlayerstack 200 Versiegelungen aufgebracht werden, um eventuell außen liegende Kanäle zu deckeln. Hierfür können auch weitere beliebige Fügeverfahren eingesetzt werden.

Fig. 20 zeigt ein Blockschaltbild einer Vorrichtung 2000 zum Herstellen einer pneumatisch betätigbaren mikrofluidischen Analysekartusche gemäß einem Ausführungsbeispiel der vorliegenden Erfindung. Die Vorrichtung weist eine Einrichtung 2002 zum Bereitstellen, eine Einrichtung 2004 zum Verschließen, eine Einrichtung 2006 zum Ausrichten und eine Einrichtung 2008 zum Verbinden auf. Die Einrichtung 2002 zum Bereitstellen ist dazu ausgebildet, einen Fluidikteil der Analysekartusche und einen Pneumatikteil der Analysekartusche bereitzustellen. Der Fluidikteil ist dazu ausgebildet, fluidische Grundoperationen eines biochemischen Analyseprozesses auszuführen. Der Pneumatikteil ist dazu ausgebildet, die Grundoperationen unter Verwendung von Druckluft anzusteuern. Die Einrichtung 2004 zum Verschließen ist dazu ausgebildet, eine Fügeseite des Fluidikteils mit einer ersten fluiddichten elastischen Membran zu verschließen. Weiterhin ist die Einrichtung 2004 zum Verschließen ist dazu ausgebildet, eine Fügeseite des Pneumatikteils mit einer zweiten Membran zu verschließen. Die Einrichtung 2006 zum Ausrichten ist dazu ausgebildet, die ersten Membran an der zweiten Membran auszurichten. Die Einrichtung 2008 ist dazu ausgebildet, den Fluidikteil und den Pneumatikteil zu verbinden, um die Analysekartusche zu erhalten.

Die beschriebenen und in den Figuren gezeigten Ausführungsbeispiele sind nur beispielhaft gewählt. Unterschiedliche Ausführungsbeispiele können vollständig oder in Bezug auf einzelne Merkmale miteinander kombiniert werden. Auch kann ein Ausführungsbeispiel durch Merkmale eines weiteren Ausführungsbeispiels ergänzt werden. Ferner können erfindungsgemäße Verfahrensschritte wiederholt sowie in einer anderen als in der beschriebenen Reihenfolge ausgeführt werden. Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

## Patentansprüche

1. Verfahren (300) zum Herstellen einer pneumatisch betätigbaren mikrofluidischen Analysekartusche (200), wobei das Verfahren (300) die folgenden Schritte aufweist:
Bereitstellen (302) eines Fluidikteils (100) der Analysekartusche (200) und eines Pneumatikteils (102) der Analysekartusche (200), wobei der Fluidikteil (100) dazu ausgebildet ist, fluidische Grundoperationen eines biochemischen Analyseprozesses auszuführen und der Pneumatikteil (102) dazu ausgebildet ist, die Grundoperationen unter Verwendung von Luftdruck anzusteuern;
Verschließen (304) einer Fügeseite (110) des Fluidikteils (100) mit einer ersten fluiddichten elastischen Membran (108) und Verschließen (304) einer Fügeseite (118) des Pneumatikteils (102) mit einer zweiten Membran (116);
Ausrichten (306) der Fügeseite (110) des Fluidikteils (100) gegenüber der Fügeseite (118) des Pneumatikteils (102); und
Verbinden (308) des Fluidikteils (100) und des Pneumatikteils (102), um die Analysekartusche (200) zu erhalten,
**dadurch gekennzeichnet, dass**
im Schritt (308) des Verbindens der Fluidikteil (100) und der Pneumatikteil (102) mechanisch aufeinander gepresst werden und die erste Membran (108) und die zweite Membran (116) zumindest teilflächig stoffschlüssig miteinander verbunden werden.

2. Verfahren (300) gemäß Anspruch 1, bei dem im Schritt des Ausrichtens die erste Membran (108) an der zweiten Membran (116) ausgerichtet wird.

3. Verfahren (300) gemäß einem der vorangegangenen Ansprüche, bei dem im Schritt (304) des Verschließens die erste Membran (108) und der Fluidikteil (100) und/oder die zweite Membran (116) und der Pneumatikteil (102) unter Verwendung von Laserenergie verbunden werden, wobei die Laserenergie auf die Fügeseite (110, 118) gerichtet ist.

4. Verfahren (300) gemäß einem der vorangegangenen Ansprüche, bei dem im Schritt (304) des Verschließens die erste Membran (108) und/oder die zweite Membran (116) zumindest teilflächig beschichtet wird, um Diffusionseigenschaften und/oder Permeationseigenschaften der Membran (108, 116) zu verändern.

5. Verfahren (300) gemäß einem der vorangegangenen Ansprüche, bei dem im Schritt (106) des Ausrichtens eine dritte elastische Membran (1100) zwischen der ersten Membran (108) und der zweiten Membran (116) angeordnet wird.

6. Verfahren (300) gemäß einem der vorangegangenen Ansprüche, bei dem im Schritt (302) des Bereitstellens der Fluidikteil (100) und/oder der Pneumatikteil (102) mit einer Einrichtung zum Abdichten (500) bereitgestellt wird, die aus der Fügefläche (110, 118) hervorsteht, wobei die Einrichtung (500) zum Abdichten im Schritt (308) des Verbindens in die erste Membran (108) und/oder die zweite Membran (116) gepresst wird, um den Fluidikteil (100) und den Pneumatikteil (102) fluiddicht zu verbinden.

7. Verfahren (300) gemäß einem der vorangegangenen Ansprüche, bei dem im Schritt (302) des Bereitstellens der Fluidikteil (100) und der Pneumatikteil (102) mit zumindest zwei Führungselementen (700, 900) bereitgestellt werden und im Schritt (306) des Ausrichtens der Fluidikteil (100) und der Pneumatikteil (102) unter Verwendung der Führungselemente (700, 900) aneinander ausgerichtet werden.

8. Verfahren (300) gemäß Anspruch 7, bei dem im Schritt (304) des Verschließens die erste Membran (108) an den Führungselementen (700, 900) des Fluidikteils (100) ausgerichtet wird und/oder die zweite Membran (116) an den Führungselementen (700, 900) des Pneumatikteils (102) ausgerichtet wird.

9. Verfahren (300) gemäß einem der vorangegangenen Ansprüche, bei dem im Schritt (304) des Verbindens der Fluidikteil (100) und/oder der Pneumatikteil (102) unter Druck gesetzt werden, um die erste Membran (108) mit der zweiten Membran (116) zu verbinden.

10. Pneumatisch betätigbare mikrofluidische Analysekartusche (200), mit folgenden Merkmalen:
einem Fluidikteil (100), der dazu ausgebildet ist, fluidische Grundoperationen eines biochemischen Analyseprozesses auszuführen;
einem Pneumatikteil (102), der dazu ausgebildet ist, die Grundoperationen unter Verwendung von Druckluft anzusteuern; und
einer ersten fluiddichten elastischen Membran (108) zum Verschließen einer Fügeseite (110) des Fluidikteils (100) und einer zweiten Membran (116) zum Verschließen (2004) einer Fügeseite (118) des Pneumatikteils (102), wobei die erste fluiddichte elastische Membran (108) und die zweite Membran (116) zwischen dem Fluidikteil (100) und dem Pneumatikteil (102) angeordnet ist,
**dadurch gekennzeichnet, dass**
der Fluidikteil (100) und der Pneumatikteil (102) mechanisch aufeinander gepresst sind und die erste Membran (108) und die zweite Membran (116) zumindest teilflächig stoffschlüssig miteinander verbunden sind.

11. Pneumatisch betätigbare mikrofluidische Analysekartusche (200) gemäß Anspruch 10, bei der die Fügeseite (110) des Fluidikteils (100) und die Fügeseite (118) des Pneumatikteils (102) aus unterschiedlichen Materialien bestehen.

## Claims

1. Method (300) for producing a pneumatically actuatable microfluidic analysis cartridge (200), wherein the method (300) has the following steps:
provision (302) of a fluidic part (100) of the analysis cartridge (200) and of a pneumatic part (102) of the analysis cartridge (200), wherein the fluidic part (100) is designed to perform fluidic basic operations of a biochemical analysis process, and the pneumatic part (102) is designed to control the basic operations using air pressure;
closure (304) of a joining side (110) of the fluidic part (100) with a first fluid-tight elastic membrane (108) and/or closure (304) of a joining side (118) of the pneumatic part (102) with a second membrane (116);
alignment (306) of the joining side (110) of the fluidic part (100) with respect to the joining side (118) of the pneumatic part (102); and
connection (308) of the fluidic part (100) and of the pneumatic part (102), in order to obtain the analysis cartridge (200),
**characterized in that**
in the step (308) of connection, the fluidic part (100) and the pneumatic part (102) are pressed onto each other mechanically and the first membrane (108) and the second membrane (116) are connected to each other cohesively over at least a partial surface area.

2. Method (300) according to Claim 1, in which, in the step of alignment, the first membrane (108) is aligned on the second membrane (116).

3. Method (300) according to either of the preceding claims, in which, in the step (304) of closure, the first membrane (108) and the fluidic part (100) and/or the second membrane (116) and the pneumatic part (102) are connected using laser energy, wherein the laser energy is directed onto the joining side (110, 118).

4. Method (300) according to one of the preceding claims, in which, in the step (304) of closure, the first membrane (108) and/or the second membrane (116) are coated over at least a partial surface area, in order to modify diffusion properties and/or permeation properties of the membrane (108, 116).

5. Method (300) according to one of the preceding claims, in which, in the step (106) of alignment, a third elastic membrane (1100) is arranged between the first membrane (108) and the second membrane (116).

6. Method (300) according to one of the preceding claims, in which, in the step (302) of provision, the fluidic part (100) and/or the pneumatic part (102) is provided with a means of sealing (500) which protrudes from the joining face (110, 118), wherein the means (500) of sealing is pressed, in the step (308) of connection, into the first membrane (108) and/or the second membrane (116), in order to connect the fluidic part (100) and the pneumatic part (102) in a fluid-tight manner.

7. Method (300) according to one of the preceding claims, in which, in the step (302) of provision, the fluidic part (100) and the pneumatic part (102) are provided with at least two guide elements (700, 900) and, in the step (306) of alignment, the fluidic part (100) and the pneumatic part (102) are aligned on each other using the guide elements (700, 900).

8. Method (300) according to Claim 7, in which, in the step (304) of closure, the first membrane (108) is aligned on the guide elements (700, 900) of the fluidic part (100), and/or the second membrane (116) is aligned on the guide elements (700, 900) of the pneumatic part (102).

9. Method (300) according to one of the preceding claims, in which, in the step (304) of connection, the fluidic part (100) and/or the pneumatic part (102) are pressurized, in order to connect the first membrane (108) to the second membrane (116).

10. Pneumatically actuatable microfluidic analysis cartridge (200), with the following features:
a fluidic part (100), which is designed to perform fluidic basic operations of a biochemical analysis process;
a pneumatic part (102), which is designed to control the basic operations using compressed air; and
a first fluid-tight elastic membrane (108) for closure of a joining side (110) of the fluidic part (100) and a second membrane (116) for closure (2004) of a joining side (118) of the pneumatic part (102), wherein the first fluid-tight elastic membrane (108) and the second membrane (116) are arranged between the fluidic part (100) and the pneumatic part (102),
**characterized in that**
the fluidic part (100) and the pneumatic part (102) are pressed onto each other mechanically and the first membrane (108) and the second membrane (116) are connected to each other cohesively over at least a partial surface area.

11. Pneumatically actuatable microfluidic analysis cartridge (200) according to Claim 10, in which the joining side (110) of the fluidic part (100) and the joining side (118) of the pneumatic part (102) are made from different materials.

## Revendications

1. Procédé (300) pour la fabrication d'une cartouche d'analyse microfluidique actionnable pneumatiquement (200), dans lequel le procédé (300) présente les étapes suivantes:
préparer (302) une partie fluidique (100) de la cartouche d'analyse (200) et une partie pneumatique (102) de la cartouche d'analyse (200), dans lequel la partie fluidique (100) est configurée pour exécuter des opérations fluidiques de base d'un processus d'analyse biochimique et la partie pneumatique (102) est configurée pour commander les opérations de base avec utilisation d'une pression d'air;
fermer (304) un côté d'assemblage (110) de la partie fluidique (100) avec une première membrane élastique étanche au fluide (108) et fermer (304) un côté d'assemblage (118) de la partie pneumatique (102) avec une deuxième membrane (116);
orienter (306) le côté d'assemblage (110) de la partie fluidique (100) par rapport au côté d'assemblage (118) de la partie pneumatique (102); et
assembler (308) la partie fluidique (100) et la partie pneumatique (102), afin d'obtenir la cartouche d'analyse (200),
**caractérisé en ce qu'**à l'étape d'assemblage (308), on presse mécaniquement l'une sur l'autre la partie fluidique (100) et la partie pneumatique (102) et on assemble matériellement l'une à l'autre, au moins sur une partie de la surface, la première membrane (108) et la deuxième membrane (116).

2. Procédé (300) selon la revendication 1, dans lequel à l'étape d'orientation on oriente la première membrane (108) sur la deuxième membrane (116).

3. Procédé (300) selon l'une quelconque des revendications précédentes, dans lequel à l'étape de fermeture (304) on assemble la première membrane (108) et la partie fluidique (100) et/ou la deuxième membrane (116) et la partie pneumatique (102) avec utilisation d'énergie laser, dans lequel l'énergie laser est dirigée sur le côté d'assemblage (110, 118).

4. Procédé (300) selon l'une quelconque des revendications précédentes, dans lequel à l'étape de fermeture (304) on revêt la première membrane (108) et/ou la deuxième membrane (116) au moins sur une partie de la surface, afin de modifier les propriétés de diffusion et/ou les propriétés de perméation de la membrane (108, 116).

5. Procédé (300) selon l'une quelconque des revendications précédentes, dans lequel à l'étape d'orientation (106) on dispose une troisième membrane élastique (1100) entre la première membrane (108) et la deuxième membrane (116).

6. Procédé (300) selon l'une quelconque des revendications précédentes, dans lequel à l'étape de préparation (302) on prépare la partie fluidique (100) et/ou la partie pneumatique (102) avec un dispositif d'étanchéité (500), qui est saillant hors de la face d'assemblage (110, 118), dans lequel on presse le dispositif d'étanchéité (500) à l'étape d'assemblage (308) dans la première membrane (108) et/ou dans la deuxième membrane (116), afin d'assembler la partie fluidique (100) et la partie pneumatique (102) de façon étanche au fluide.

7. Procédé (300) selon l'une quelconque des revendications précédentes, dans lequel à l'étape de préparation (302) on prépare la partie fluidique (100) et la partie pneumatique (102) avec au moins deux éléments de guidage (700, 900) et à l'étape d'orientation (306) on oriente la partie fluidique (100) et la partie pneumatique (102) l'une sur l'autre avec utilisation des éléments de guidage (700, 900).

8. Procédé (300) selon la revendication 7, dans lequel à l'étape de fermeture (304) on oriente la première membrane (108) sur les éléments de guidage (700, 900) de la partie fluidique (100) et/ou la deuxième membrane (116) sur les éléments de guidage (700, 900) de la partie pneumatique (102).

9. Procédé (300) selon l'une quelconque des revendications précédentes, dans lequel à l'étape d'assemblage (304) on met sous pression la partie fluidique (100) et/ou la partie pneumatique (102) afin d'assembler la première membrane (108) à la deuxième membrane (116).

10. Cartouche d'analyse microfluidique actionnable pneumatiquement (200), présentant les caractéristiques suivantes:
une partie fluidique (100), qui est configurée pour exécuter des opérations fluidiques de base d'un processus d'analyse biochimique;
une partie pneumatique (102), qui est configurée pour commander les opérations de base avec utilisation d'air comprimé;
une première membrane élastique étanche au fluide (108) pour fermer un côté d'assemblage (110) de la partie fluidique (100) et une deuxième membrane (116) pour fermer (2004) un côté d'assemblage (118) de la partie pneumatique (102), dans lequel la première membrane élastique étanche au fluide (108) et la deuxième membrane (116) est disposée entre la partie fluidique (100) et la partie pneumatique (102), **caractérisé en ce que** la partie fluidique (100) et la partie pneumatique (102) sont pressées mécaniquement l'une sur l'autre et la première membrane (108) et la deuxième membrane (116) sont matériellement assemblées l'une à l'autre au moins sur une partie de la surface.

11. Cartouche d'analyse microfluidique actionnable pneumatiquement (200) selon la revendication 10, dans laquelle le côté d'assemblage (110) de la partie fluidique (100) et le côté d'assemblage (118) de la partie pneumatique (102) sont constitués de matériaux différents.
